(19) Europäisches Patentamt
European Patent Office
Office européen des brevets

(11) **EP 2 903 166 A1**

(12) **EUROPEAN PATENT APPLICATION**

(43) Date of publication:
**05.08.2015 Bulletin 2015/32**

(51) Int Cl.:
**H03M 13/11** *(2006.01)*

(21) Application number: **14290024.0**

(22) Date of filing: **03.02.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
• **Centre National de la Recherche Scientifique (CNRS)**
**75016 Paris (FR)**
• **Université Cergy-Pontoise**
**95000 Cergy (FR)**
• **Universitat Politècnica de València**
**46022 Valencia (ES)**

(72) Inventors:
• **Leclerq, David**
**95450 Ableiges (FR)**
• **Li, Erbao**
**Zhengzhou Henan**
**450007 PRC P.R. (CN)**
• **Garcia Herrero, Francisco Miguel**
**46702 Gandia (ES)**
• **Valls Coquilat, Javier**
**46760 Tavernes de la Valldigna (ES)**

(74) Representative: **Regimbeau**
**20, rue de Chazelles**
**75847 Paris Cedex 17 (FR)**

(54) **Multiple-vote symbol-flipping decoder for non-binary LDPC codes**

(57)   The invention concerns an extension to the enhanced serial generalized bit-flipping decoding algorithm (ES-GBFDA) for non-binary LDPC codes by introducing soft information in the check node operation. Contrary to the ES-GBFDA, the application not only considers the most reliable symbols in the syndrome computation, but also takes at least the second most reliable symbol in each incoming message into account. By doing so, an extended information set is available for the parity-check node update and this allows introducing the concept of weak and strong votes, performed by the check node unit. With this feature, each variable node can receive two kinds of votes, whose amplitude can be tuned to the reliability of the syndrome that produces the vote.

FIG. 4

**Description**

FIELD OF THE INVENTION

The invention concerns the decoding of error correcting codes in the field of telecommunications and data storage. More specifically the invention concerns a decoding method and the corresponding decoder for non-binary Low-Density Parity Check (LDPC) codes.

BACKGROUND

The design of high-throughput decoders for non-binary low-density parity-check (NB-LDPC) codes in GF(q), with moderate silicon area, is a challenging problem, which requires both low complexity algorithms and efficient architectures.

Algorithms derived from the q-ary sum-product (QSPA) [1], [2], [3], [4] such as extended min-sum (EMS) [5] and min-max (Min-Max) [7] involve high complexity in their check node units (CNU), that implement the parity-check node update equations. In particular, the CNU of the different versions of EMS or Min-Max requires many comparisons, which reduce the maximum achievable throughput, due to a large inherent latency. This high latency is a bottleneck, especially for the decoding of high rate NB-LDPC codes (R>0.8), where the parity-check node degree $d_c$ takes large values. Techniques like forward-backward implementation of the CNU [8], [10] or the bubble check algorithm [9] can reduce the latency to a minimum of dc clock cycles, with enough hardware parallelism, but this is still not sufficient to reach very high throughput. As a result, the architectures based on EMS or Min-Max algorithms [13], [14], [15] can achieve coding gains close to QSPA, but at the cost of low decoding throughput.

Aside from the EMS or Min-Max like algorithms, other solutions have been proposed in the literature, with the objective of greatly reducing the decoding complexity at the cost of larger performance loss compared to QSPA. The architectures that can achieve high throughput, and at the same time use a small chip area, just compute a very small set of parity check equations during the parity-check node update. This approach has been followed for majority-logic decodable (MD) algorithm [11] and generalized bit flipping-decoding algorithm (GBFDA) [12]. These simple algorithms, and the associated architectures [21], [17], [18] suffer from a non-negligible performance loss compared to the QSPA, between 0.7 dB to several dBs depending on the algorithm and the LDPC code. This performance loss is due to the lack of soft- information used in the CNUs of GBFDA and MD, and cannot be recovered with a larger number of decoding iterations [18]. In addition, GBFDA and MD tend to be more efficient for codes with medium variable node degrees ($d_v$ > 3 in the case of GBFDA), and do not perform well for ultra-sparse $d_v$ = 2 NB-LDPC codes, which have been identified as an important class of non-binary codes [6].

SUMMARY OF THE INVENTION

The invention permits to improve the performance of the decoding of a non-binary low density parity-check (NB-LDPC).

To this end the invention concerns a method for decoding a non-binary low density parity-check code defined in a finite field of size q, the code can be displayed in a bipartite graph comprising at least one variable node $V_n$, $n$ = 0, ...,$N$ -1 and at least one check node $C_m$, $m$ = 0, ..., $M$ - 1, said method comprising for each iteration $j$ of $I_t$ decoding iterations, the steps consisting in that:

each variable node $V_n$, connected to a check node $C_m$, is configured for determining a most reliable symbols $Q_n^{1(j)}$ and at least one symbol which is at least a $p^{th}$ most reliable symbol $Q_n^{p(j)}$ , with $p \geq 2$ for obtaining a vector of dc most reliable symbols;
each check node $C_m$ is configured for determining:

a first symbol to be voted $R_n^{0(j)} = R_n^{(j)}$ based on the vector of $d_c$ most reliable symbols passed by the variable nodes connected to him in the bipartite graph;
a list of $i$ = 1, ..., $L$ second symbol to be voted $R_n^{i(j)}$ based on a list of L+1test vectors defined as a combination of $d_c$ symbols with a restriction according to which at most $\eta$ of these $d_c$ symbols are a $p^{th}$ most reliable symbol $Q_n^{p(j)}$ with $p \geq 2$, and at least $d_c$ - $\eta$ of these $d_c$ symbols are a most reliable symbol $Q_n^{1(j)}$.

The method according to the invention may have one of the following features:

- Each variable node is configured for determining the most reliable symbols $Q_n^{(j)}$ and the second most reliable symbol $Q_n^{2(j)} = Q_n'^{(j)}$ and their corresponding extrinsic reliability $\Delta W_n^{(j)}$, $\Delta W_n'^{(j)}$ so that at a check node the list of L+1 test vectors are built by replacing symbol $Q_n^{(j)}$ by the second most reliable symbol $Q_n'^{(j)}$ in at most $\eta \le L$ locations were the differences between $\Delta W_n^{(j)}$ and $\Delta W_n'^{(j)}$ are the smallest.

- For $\eta \le L$, it comprises a step consisting in that a sorter unit is configured for sorting the differences of extrinsic reliability $\Delta W_{nm}^{(j)} - \Delta W_{nm}^{2(j)}$ from the highest value to the lowest value for obtaining a sequence N' of L sorted indices n, the sequence N' comprising the $\eta$ locations where $Q_n^{(j)}$ is replaced by $Q_n^{2(j)}$ in the L+1 test vectors.

- Each variable node is further configured for computing an intrinsic information $\mathbf{W}_{mn}^{(j)}$ from check node counting the votes of $R_n^{0(j)}$ and of $R_n^{i(j)}$ with the respectively amplitude voting $v_0$, $v_2$.

- It comprises before the $l_t$ decoding iterations an initialization step comprising the sub-steps of:

> determining a LLR vector $L_n$ = ($L_n[0]$, $L_n[1]$,...,$L_n[q - 1]$) of a $n^{th}$ symbol in a sequence of N non-binary noisy symbols;
> initializing a vector of APP vectors $\mathbf{W}_n^{(0)}$ to the LLR vector $L_n$ and initializing a matrix $\mathbf{W}_{mn}^{(0)}$ to an all-zero matrix, said matrix $\mathbf{W}_{mn}^{(j)}$ being the intrinsic information from the check node m.

- Each variable node taking as input the LLR vector and the vector $\mathbf{W}_{mn}^{(j)}$ combines the previous vector $\mathbf{W}_{mn}^{(j-1)}$, the voting symbols $R_n^{0(j)}$ and of $R_n'^{(j)}$ and the voting amplitudes $v_0$, $v_1$ through a function $F_1$ for obtaining the vector defined as the intrinsic information $\mathbf{W}_{mn}^{(j)}$.

- The function $F_1$ is a simple summation of the values of the previous vector $\mathbf{W}_{mn}^{(j-1)}$ at indices indicated by the voting symbols $R_n^{0(j)}$ and of $R_n^{i(j)}$ and the voting amplitudes $v_0$, $v_1$.

- The LLR vector and the vector $\mathbf{W}_n^{(j)}$ combines (A5.1, A5.2) the previous vector $\mathbf{W}_n^{(j-1)}$ $\mathbf{W}_{mn}^{(j-1)}$, the voting symbols $R_n^{0(j)}$ and of $R_n^{i(j)}$ and the voting amplitudes $v_0$, $v_1$ through a function $F_2$ for obtaining the vector $\mathbf{W}_n^{(j)}$,

- The function $F_2$ is a simple summation of the values of the previous vector $\mathbf{W}_n^{(j-1)}$ at indices indicated by the voting symbols $R_n^{0(j)}$ and of $R_n^{i(j)}$ and the voting amplitudes $v_0$, $v_1$.

The invention also concerns, a decoding apparatus comprising at least one variable node $V_n$ and a at least one check node $C_m$, said decoder being configured for implementing a method for decoding a non-binary low density parity-check code defined in a finite field of size q, according to the invention.

The decoding apparatus of the invention may have one of the following features:

- It is configured for implementing check node operations by means of L processing units configured dynamically to compute $R_n^{i(j)}$, with $i$ = 1, ..., L, each one of the L processing units share $3xd_c$ inputs that correspond to the symbols $Q_n^{1(j)}, Q_n^{2(j)}$ and to the coefficients of the code, said inputs of each processing unit are combined by means of $2xd_c$ GF multipliers and $2xd_c$ GF adders, said processing units including all the logic necessary to compute L different syndromes as an intermediate step and a variable number of pipeline stages that may vary from 0 to $log2(d_c)$ + 2 depending on the speed of said processing unit.

- It is configured for implementing the method of the invention and comprises i) a bank of memories that store $R_n^{i(j)}$,

with $i = 0, ..., L$ symbols, ii) q processors with a logic required to compare the symbols $R_n^{i(j)}$, with $i = 0, ..., L$, with the q elements of the Galois Field and determine the amplitude of the votes corresponding to that symbols; and iii) q cells that implement functions $F_1$ and $F_2$, the bank of memories being implemented with L RAM memories or a bank of L registers., the processors being implemented with L-XNOR gates of $log2(q)$ bits and L-OR gates of 1 bit to compare the input symbols (symbols $R_n^{i(j)}$, with $i = 0,...,L$,) with the q Galois Field elements and determine the amplitude of the votes, the cells including a logic necessary for implementing $F_1$ and $F_2$ and the storage resources for $\mathbf{W}_{mn}^{(j)}$ and $\mathbf{W}_n^{(j)}$.

- It comprises a sorter unit configured for obtaining the sequence $\mathcal{N}$ of L sorted indices n according to the method of the invention, the sorter unit including at least one sub-processors of radix L, each sub-processor including: i) one stage of comparators configured for performing all the possible combinations of the inputs; ii) a plurality of adders and a plurality of NOT gates configured for computing a summation of the output signals of the different comparators associated to the same input, the adders being configured for checking how many times a condition of greater than or less than is satisfied for each one of the inputs; iv) a plurality of logic gates configured for implementing a L different masks that allows ordering the inputs according to the information provided by the outputs of the adders, logic gates are XNOR, OR and AND gates.

The invention permits to achieve both a high throughput and a coding gain as close as possible to QSPA, by taking advantage of the low complexity of GBFDA operations and introduces soft information in the CNU, as it is done in EMS and Min-Max, to improve the coding gain.

The core idea of the ES-GBFDA CNU is to compute the syndrome using the hard decisions on the symbols, obtained from the most reliable Galois field values, and declare a vote for the hard decision symbols which satisfy the parity-check. The vote is then propagated to the symbol nodes and accumulated along the decoding iterations in a memory.

Contrary to ES-GBFDA, the invention not only considers the most reliable symbols in the syndrome computations, but also to take at least the second most reliable symbols (in each incoming message) into account. By doing so, an extended information set is available for the parity-check node update and this allows introducing the concept of *weak* and *strong* votes, performed by the CNU, and propagated to the symbol node memory. With this feature, each variable node can receive two kinds of votes, whose amplitude can be tuned to the reliability of the syndrome that produces the vote.

For this reason, the decoding method of the invention can be called multiple-vote symbol- flipping decoder (MV-SF).

At the MV-SF CNU, we call *test vector* a set of symbols taken from the most reliable and the second most reliable symbols of each incoming message.

The invention introduces some extra soft-information and enlarges the list of considered test vectors, therefore, improving the decoding performance. Meanwhile, the complexity of the CNU for each extra test vector is the same as GBFDA, which gives the method of the invention the nice feature of controlling the performance/complexity trade-off: the more test vectors are considered, the better the performance is, and the less test vectors are considered, the better the throughput is.

As an example, a decoder with four times more test vectors than the ES-GBFDA, on a (N = 837, K = 723) NB-LDPC code over GF(32), shows a coding gain of 0.44dB compared with GBFDA and has just a performance loss of 0.21dB compared to Min-Max. Moreover, the associated architecture can reach a throughput similar to the ES-GBFDA [18] with an increase of area less than two times, not four times as expected from a direct architecture mapping.

The invention improves the coding gain of ES-GBFDA by creating a list of test vectors that increases the amount of soft information in the check node update. The variable node is also modified to introduce different amplitudes in the votes involved in the computation, with the objective of distinguishing if the vote is produced by the most reliable information or by both most and second most reliable symbols. With the invention, the gap of performance between ES-GBFDA and Min-Max or EMS is reduced.

Derived from the method of the invention, a high throughput architecture of a decoder is proposed. Area required is less than L/2 times area of the ES-GBFDA, being L the size of the list of test vectors. This fact demonstrates the optimization of the architecture, which does not increase its area L times, as it would be the case of a direct mapping solution. The invention, even overestimating area, reaches at least 27% more efficiency (throughput/area) compared to the best Min-Sum and Min-Max architectures, with the cost of only 0.21dB performance loss. The invention based on GBFDA can reach similar performance to EMS and Min-Max, but with the advantage of higher throughputs.

BRIEF DESCRIPTION OF THE DRAWINGS

Other features and advantages of the invention will appear in the following description with references to the drawings, in which:

- Figure 1a illustrates a bipartite graph of the method of the invention;
- Figure 1b illustrates a single variable node of the method of the invention;
- Figures 1c and 1d illustrate a single check node of the invention;
- Figure 2 illustrates a structure to generate the L sorted indices in the method of the invention;
- Figure 3 illustrates a variable node receiving information from a check node according to the invention;
- Figure 4 illustrates an architecture of a decoder of the invention;
- Figures 5a and 5b illustrate architecture of check node units of the decoder of the invention;
- Figure 6 illustrates architecture of variable node units of the decoder of the invention;
- Figure 7 illustrates a CELL of variable node units of the decoder of the invention;
- Figure 8 illustrates a general architecture for a sorter unit of the invention for a 4-minimum finder in a 27 element list;
- Figures 9a and 9b illustrate an architecture for the first stage (l=0) of the sorter unit of Figure 8;
- Figure 10 illustrates architecture for stages different from the first (l>0) of the sorter unit of Figure 8;
- Figure 11 illustrates theoretical estimation of area-complexity for the decoder of the invention based on a message passing architecture;
- Figure 12 illustrates theoretical estimation of area-complexity for R minimum finder in a dc list.

DETAILED DESCRIPTION

A method for decoding a non-binary low density parity-check (NB-LDPC) code defined in a finite field of size $q$ is based on a bipartite graph comprising at least one variable node $V_n$, $n = 0, ..., N - 1$ and at least one check nodes $C_m$, $m = 0, ..., M - 1$.

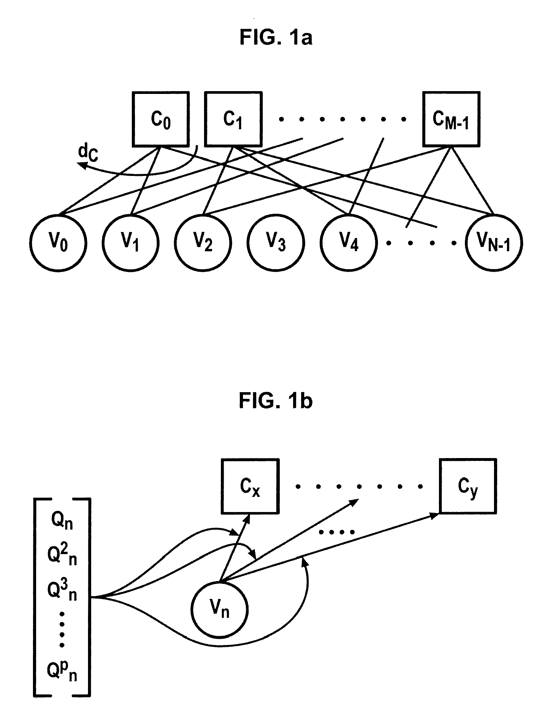

**Figure 1a** illustrates a bipartite graph with $M$ check nodes $C_m$, $m = 0, ..., M - 1$ and $N$ variable nodes $V_n$, $n = 0, ..., N - 1$. As shown on this figure, each check node $C_m$ is connected to $d_c$ variables nodes $V_n$.

NB-LDPC notations

Let us define a $(N,K)$ NB-LDPC code over $GF(q)$ ($q = 2^p$) with code length $N$ and information length $K$. Its parity check matrix $H_{M,N}$ has $N$ columns and $M$ rows. The non-zero coefficients of $H_{M,N}$ are $h_{m,n}$, where $m$ is the row index and n the column index. The check node degree is denoted as $d_c$ and the variable node degree as $d_v$. $\mathcal{N}(m)$ defines the set of variables nodes connected to the $m$ - th check node, and $\mathcal{M}(m)$ the set of check nodes connected to the $n$ - th variable node. After transmission over a noisy Additive White Gaussian Noise (AWGN) channel, the received symbol sequence is defined as Y = $(y_0, y_1, ..., y_{N-1})$. Considering the transmission of the codeword symbol $C_n$, the log-likelihood ration (LLR) is computed as $L_n[x] = \log[P(c_n = 0)|y_n)/P(c_n = x|y_n)]$, for *each x E GF(q)*. The LLR vector of the $n$ - th symbol is $L_n = (L_n[0], L_n[1], ..., L_n[q - 1])$. The hard-decision based on the most reliable element in $L_n$ is called $z_n \in GF(q)$.

Enhanced Serial GBFDA (ES-GBFDA)

The method for decoding a NB-LDPC code according to the invention is an improvement of the ES-GBFDA. Before explaining the method of the invention we briefly describe this known improved algorithm, especially the ES-GBFDA from [18] called "Algorithm 1" above.

In this Algorithm 1, two main steps can be distinguished in the iterative process the check node unit (CNU), steps A2 and A3; and the variable node unit (VNU), steps A1, A4 and A5.

During the initialization, $\mathbf{W}_n^{(0)}$ equals to the channel LLRs, $L_n$, and $\mathbf{W}_{mn}^{(0)}$ is an all-zero matrix. After initialization, at the j-th iteration, step A1 sorts the extrinsic information to find the symbols $Q_n^{(j)}$ with the maximum reliability (GFmax), which will be taken as the new hard decision.

The extrinsic information is calculated as $\mathbf{W}_n^{(j-1)} - \mathbf{W}_{mn}^{(j-1)}$. $\mathbf{W}_n^{(j-1)}$ is the vector where all the votes are accumulated and the $\mathbf{W}_{mn}^{(j-1)}$ is the intrinsic information from check node $C_m$. Step A2 computes the syndrome $s$, required in step A3 to calculate $R_n^{(j)}$, which is the symbol to be voted. In step A4, $\mathbf{W}_{mn}^{(j)}$ counts the votes on $R_n^{(j)}$ where $v$ is the

amplitude of the vote. In step A5, $\mathbf{W}_n^{(j)}$ accumulates the initial LLRs plus the votes of all the check nodes connected to the variable node $V_m$. The votes modify the values of $\mathbf{W}_n^{(j-1)}$ and $\mathbf{W}_{mn}^{(j-1)}$, changing the result of the sorting process in A1 and, hence, flipping symbols in $Q_n^{(j)}$. Step A6 performs the tentative decoding by finding the symbols associated to the maximum values of $\mathbf{W}_n^{(j)}$ and step A7 implements the stopping criterion based on the information of all the syndromes. The decoded codeword is then $\tilde{c}_n^{(j)}$.

---

**Algorithm 1. Serial Enhanced-GBFDA**

---

Initialization: $\mathbf{W_n}^{(0)} = \mathbf{L_n}$, $\mathbf{W_{mn}}^{(0)} = 0$
For $j = 1$ to $It_{max}$
  For $m = 1$ to $M$
    A1 : $Q_n^{(j)} = GFmax(\mathbf{W_n}^{(j-1)} - \mathbf{W_{mn}}^{(j-1)})$
    A2 : $s = \sum_{n \in N(m)} h_{m,n} Q_n^{(j)}$
    A3 : $R_n^{(j)} = h_{mn}^{-1} s - Q_n^{(j)}$
    A4 : $\mathbf{W_{mn}}^{(j)}(R_n^{(j)}) = \mathbf{W_{mn}}^{(j-1)}(R_n^{(j)}) + v$
    A5 : $\mathbf{W_n}^{(j)}(R_n^{(j)}) = \mathbf{W_n}^{(j-1)}(R_n^{(j)}) + v$
  end For $m$
  A6 : $\tilde{c}_n^{(j)} = GFmax(\mathbf{W_n}^{(j)})$
  A7 : if $(\tilde{c}_n^{(j)} \times \mathbf{H}^T = 0)$ SKIP
end For $j$
Output= $\tilde{c}_n^{(j)}$

---

<u>General presentation of the method of the invention called as Multiple Vote Symbol Flipping Decoding Algorithm (MV-SF)</u>

We now describe, in a general way, the method of the invention based on the ES-GBFDA, by increasing the list of candidates computed by each check node and hence, increasing as well the number of votes propagated to the variable node. We only present the steps involved at the j-th decoding iteration.

Let $Q_n^{(j)}$ be the hard decision obtained from the most reliable symbols, and $Q_n^{p(j)}$ the hard decision of the p-th most reliable symbol within the input messages of a check node $C_m$. We only consider the most reliable symbol $Q_n^{(j)}$ and the second most reliable symbol $Q_n^{2(j)} = Q_n'^{(j)}$. The symbols $Q_n^{(j)}$ (respectively $Q_n^{2(j)}$) are associated with relia-bilities $\Delta W_n^{(j)}$ (respectively $\Delta W_n^{2(j)} = \Delta W_n'^{(j)}$).

We define test vector for a check node $C_m$ as the combination of $d_c$ symbols with the restriction that at least one, and at most $\eta$ of these $d_c$ symbols cannot be based on the most reliable information. In order to reduce the number of test vector candidates we only consider combinations between $Q_n^{(j)}$ and $Q_n'^{(j)}$. To build the list of test vectors of a check node $C_m$, first the difference between the reliability of $\Delta W_n^{(j)}$ and $\Delta W_n'^{(j)}$ is computed and sorted in ascendant order for $n \in \mathcal{N}(m)$. The first elements of the sorted differences are the symbols in which the reliability of $Q_n'^{(j)}$ is closer to the reliability of $Q_n^{(j)}$. To keep the number of test vectors low we only replace $Q_n^{(j)}$ by $Q_n'^{(j)}$ in at most $\eta$ locations were the differences between $\Delta W_n^{(j)}$ and $\Delta W_n'^{(j)}$ is smaller (first $\eta$ elements of the sorted list). The parameter $\eta$ tunes the performance/complexity trade-off of the algorithm since it is directly related to with the number of test vectors to be processed by each check node. $\eta$ is selected as $\eta << d_c$ to keep complexity low. The set with the $\eta$ locations is denoted N'.

Let us define $\Gamma_i^{(j)}$ as the i-th test vector of a list $2^\eta - 1$ possible test vectors of a check node m, different from the one based only on $Q_n^{(j)}$ symbols. Each $\Gamma_i^{(j)}$ is built replacing $Q_n^{(j)}$ with $Q_n'^{(j)}$.

In Equation (1) the definition of the test vector $\Gamma_i^{(j)}$ is indicated where $\mathcal{N}'_t$ is the t-th element in the set $\mathcal{N}'$, $i_t$ is the bit t of the binary representation of $i$ and $\bar{\iota}_t$ is the complementary value. Operator $\otimes$ and $\oplus$ are the 'AND' and

'OR' operations respectively.

$$\Gamma_i^{(j)} \in \{Q_n^{(j)}, Q'^{(j)}_{\mathcal{N}'_t} \otimes i_t \oplus Q^{(j)}_{\mathcal{N}'_t} \otimes \overline{i_t}\},$$
$$n \in \mathcal{N}(m) \setminus \mathcal{N}', t = 0 \ \ to \ \ \eta - 1 \qquad (1)$$

In the same way, we can define the reliability of each $\Gamma_i^{(j)}$, $\omega_i^{(j)}$, by means of Equation (2).

$$\omega_i^{(j)} = \sum_{n \in \mathcal{N}(m) \setminus \mathcal{N}'} \Delta W_n^{(j)} +$$
$$\sum_{t=0:\eta-1} \Delta W'^{(j)}_{\mathcal{N}'_t} \times i_t + \Delta W^{(j)}_{\mathcal{N}'_t} \times \overline{i_t} \qquad (2)$$

Description of a preferred embodiment of the method of the invention

We now consider a case wherein each check node is composed of $L = \eta$ test vectors. Each test vector has $d_c$ - 1 $Q_n^{(j)}$ symbols, and one $Q'^{(j)}_n$ symbol. The position of the $Q'^{(j)}_n$ symbol in the test vector $i$, $\Gamma_i^{(j)}$ is given by $N'_i$ as follows:

$$\Gamma_i^{(j)} \in \{Q_n^{(j)}, Q'^{(j)}_{\mathcal{N}'_t}\}, n \in \mathcal{N}(m) \setminus \mathcal{N}'_t \qquad (3)$$

The reliability equation for the test vector $\Gamma_i^{(j)}$ is given by

$$\omega_i^{(j)} = \sum_{n \in \mathcal{N}(m) \setminus \mathcal{N}'_t} \Delta W_n^{(j)} + \Delta W'^{(j)}_{\mathcal{N}'_t} \qquad (4)$$

It can be deduced from Equation (4) that changing $Q_n^{(j)}$ by $Q'^{(j)}_n$ in $N'_i$ does not introduce a strong variation in the total reliability of the check node, $\omega_i^{(j)}$. The only element that changes in the sum is $\Delta W^{(j)}_{N'_i}$, which is selected because the difference $\Delta W^{(j)}_{N'_i} - \Delta W'^{(j)}_{N'_i}$ is one of the $\eta$ smallest (so both $Q^{(j)}_{N'_i}$ and $Q'^{(j)}_{N'_i}$ have similar reliability in the selected location $N'_i$).

In other words, as $\Gamma_i^{(j)}$ has a high reliability, similar to $Q_n^{(j)}$, processing its candidates increases the amount of useful soft-information in the decoder and hence improves the performance.

To keep the complexity low and avoid computing and storing (4) for each test vector, function $\mathcal{F}\left(\omega_i^{(j)}\right)$ has to be very simple.

In a preferred embodiment of the invention, only two amplitudes for the votes are considered $v_0$ for the symbol candidates derived from the most reliable test vector, and $v_1$ for the other test vectors, $v_0 > v_1$. However, this latter condition for the amplitudes $v_0$ and $v_1$ is necessary but not sufficient to obtain the best efficiency and performance. As already mentioned, the distance between the amplitudes is, with $\eta$, the most important parameter to be optimized. If $v_0$ and $v_1$ are too close the amplitudes of the votes will be mixed easily and the flipping of the symbols will be done almost without any criterion, as candidates with very different reliability values will have almost the same vote amplitude. If the difference between $v_0$ and $v_1$ is too large, the votes of the less reliable test vectors will be not taken into account and the effect will be similar as not having an extended list of candidates. On the other hand, the values $v_0$ and $v_1$ also have to be scaled according to the channel information. Unlike other algorithm as EMS or Min-max were all the information is strongly related with the incoming LLRs, algorithms based on voting process mix two different domains, the one with channel information and the one based on votes. It is easy to deduce that some kind of normalization is required for vote amplitudes or for channel information in order to combine them properly. Hence, we need to optimize the amplitudes of the votes $v_0$ and $v_1$, and also their combination with the LLR information, through the function $\mathcal{F}$.

In the preferred embodiment of the invention called "Algorithm 2" above, $L = \eta$. It can be seen that some steps of this Algorithm 2 are similar to some steps of Algorithm 1 (i.e., ES-GBFDA).

---

**Algorithm 2. Multiple-Vote Symbol Flipping Decoding Algorithm**

Initialization: $\mathbf{W_n}^{(0)} = \mathbf{L_n}$, $\mathbf{W_{mn}}^{(0)} = 0$,
$\quad\quad\quad\quad\quad$ $L =$ size of the expanded list
For $j = 1$ to $It_{max}$
$\quad$ For $m = 1$ to $M$
$\quad\quad$ A1.1 : $\Delta W_n^{(j)} = max_0(\mathbf{W_n}^{(j-1)} - \mathbf{W_{mn}}^{(j-1)})$
$\quad\quad\quad\quad$ $Q_n^{(j)} = GFmax_0(\mathbf{W_n}^{(j-1)} - \mathbf{W_{mn}}^{(j-1)})$
$\quad\quad$ A1.2 : $\Delta W_n^{'(j)} = max_1(\mathbf{W_n}^{(j-1)} - \mathbf{W_{mn}}^{(j-1)})$
$\quad\quad\quad\quad$ $Q_n^{'(j)} = GFmax_1(\mathbf{W_n}^{(j-1)} - \mathbf{W_{mn}}^{(j-1)})$
$\quad\quad$ A1.3 : $\mathcal{N}' = IndexSortAscendant(\Delta W_n^{(j)} - \Delta W_n^{'(j)}), n \in N(m)$
$\quad\quad$ A2.1 : $s = \sum_{n \in N(m)} h_{m,n} Q_n^{(j)}$
$\quad\quad$ A2.2 : For $i = 1$ to $L$
$\quad\quad\quad\quad$ $s_i' = s - h_{m,\mathcal{N}_i'} Q_n^{(j)} + h_{m,\mathcal{N}_i'} Q_{\mathcal{N}_i'}^{'(j)}$
$\quad\quad\quad$ end For $i$
$\quad\quad$ A3.1 : $R_n^{(j)} = h_{mn}^{-1} s - Q_n^{(j)}$
$\quad\quad$ A3.2 : For $i = 1$ to $L$
$\quad\quad\quad\quad$ $R_{n-i}^{'(j)} = h_{mn}^{-1} s_i' - Q_n^{(j)}, n \in N(m) \setminus \mathcal{N}_i'$
$\quad\quad\quad\quad$ $R_{n-i}^{'(j)} = h_{mn}^{-1} s_i' - Q_n^{'(j)}, n = \mathcal{N}_i'$
$\quad\quad\quad$ end For $i$
$\quad\quad$ A4.1 : $\mathbf{W_{mn}}^{(j)}(R_n^{(j)}) = \mathbf{W_{mn}}^{(j-1)}(R_n^{(j)}) + v_0$
$\quad\quad$ A4.2 : For $i = 1$ to $L$
$\quad\quad\quad\quad$ $\mathbf{W_{mn}}^{(j)}(R_{n-i}^{'(j)}) = \mathbf{W_{mn}}^{(j-1)}(R_{n-i}^{'(j)}) + v_1$
$\quad\quad\quad$ end For $i$
$\quad\quad$ A5.1 : $\mathbf{W_n}^{(j)}(R_n^{(j)}) = \mathbf{W_n}^{(j-1)}(R_n^{(j)}) + v_0$
$\quad\quad$ A5.2 : For $i = 1$ to $L$
$\quad\quad\quad\quad$ $\mathbf{W_n}^{(j)}(R_{n-i}^{'(j)}) = \mathbf{W_n}^{(j-1)}(R_{n-i}^{'(j)}) + v_1$
$\quad\quad\quad$ end For $i$
$\quad$ end For $m$
$\quad$ A6 : $\bar{c}_n^{(j)} = GFmax(\mathbf{W_n}^{(j)})$
$\quad$ A7 : if $(\bar{c}_n^{(j)} \times \mathbf{H}^T = 0)$ SKIP
end For $j$
Output= $\bar{c}_n^{(j)}$

---

The method of the invention, above, comprises $I_t$ decoding iterations. In the following, the method is described at each iteration j.

Before, the $I_t$ decoding iterations an initialization step, Initialization, comprises the sub-steps of:

determining a LLR vector $L_n = (L_n[0], L_n[1], ..., L_n[q - 1])$ of a $n^{th}$ symbol in a sequence of $N$ non-binary noisy symbols;

initializing a vector of APP vectors $\mathbf{W}_n^{(0)}$ to the LLR vector $L_n$ and initializing a matrix $\mathbf{W}_{mn}^{(0)}$ to an all-zero matrix, said matrix $\mathbf{W}_{mn}^{(j)}$ being the intrinsic information from the check node m.

In steps A1.1 and A1.2 each variable node $V_n$ connected to a check node $C_m$ is configured for determining a most reliable symbols $Q_n^{1(j)}$ and at least one symbol which is at least a $p^{th}$ most reliable symbol $Q_n^{p(j)}$, with $p \geq 2$ for obtaining a vector of dc most reliable symbols. **Figure 1b** illustrates the principles of these steps A1.1 and A1.2.

In particular steps A1.1 and A1.2 search the extrinsic information of the most reliable symbols : $\Delta W_n^{(j)}$ (max1),

and their associated hard decision symbols $Q_n^{(j)}$ and $Q_n'^{(j)}$.

Furthermore, each variable node $n = 0, ..., d_c - 1$ is configured for determining (the most reliable symbols $Q_n^{(j)}$ and the second most reliable symbol $Q_n'^{(j)}$ and their corresponding extrinsic reliability $\Delta W_n^{(j)}$, $\Delta W_n'^{(j)}$ so that at a check node m the list of L+1 test vectors are built by replacing symbol $Q_n^{(j)}$ by the second most reliable symbol $Q_n'^{(j)}$ in at most $\eta \le L$ locations were the differences between $\Delta W_n^{(j)}$ and $\Delta W_n'^{(j)}$ are the smallest, with $\Delta W_n^{(j)} = W_n^{(j)} - W_{nm}^{(j)}$.

Based on the dc most reliable symbols, each check node $C_m$ is configured for determining:

in step A3.1, a first symbol to be vote $R_n^{0(j)}$ based on the vector of $d_c$ most reliable symbols passed by the variable nodes connected to him in the bipartite graph;

in step A3.2, a list of i = 1, ..., L second symbol to be voted $R_n^{i(j)}$ based on a list of L+1 test vectors defined as a combination of $d_c$ symbols with a restriction according to which at most $\eta$ of these $d_c$ symbols are a $p^{th}$ most reliable symbol $Q_n^{p(j)}$ with $p \ge 2$, and at least $d_c - \eta$ of these $d_c$ symbols are a most reliable symbol $Q_n^{(j)}$.

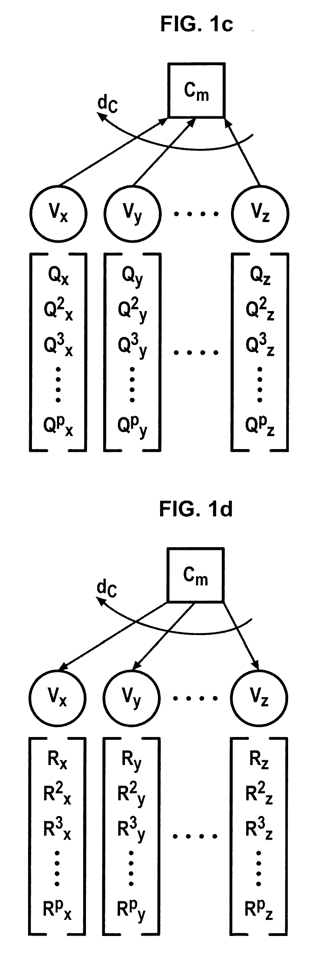

Figure **1c** and Figure **1d** illustrate the principles of steps A3.1 and A3.2. On these figures, a check node is connected to three variable nodes x; y, z. A check node receives dc vectors of p elements from dc different variables nodes and computes dc vectors of p symbols. The information computed by the check node is sent to dc different variable nodes.

It can be seen that comparatively with Algorithm 1, each check node performs more operations than a check node of Algorithm 1. Further, step A3.1 is the same as A3 in algorithm 1.

Furthermore, each variable node is configured for determining in steps A1.1 and A1.2 the most reliable symbols $Q_n^{(j)}$ and the second most reliable symbol $Q_n'^{(j)}$ and their corresponding extrinsic reliability $\Delta W_n^{(j)}$, $\Delta W_n'^{(j)}$ so that at a check node in steps A2.1 and A2.2 the list of L+1 test vectors are built by replacing symbol $Q_n^{(j)}$ by the second most reliable symbol $Q_n'^{(j)}$ in at most $\eta \le L$ locations were the differences between $\Delta W_n^{(j)}$ and $\Delta W_n'^{(j)}$ are the smallest, with $\Delta W_n^{(j)} = W_n - W_{nm}$.

The method of the invention also comprises a step consisting in that a sorter unit is configured for sorting in step A1.3 the differences of extrinsic reliability $\Delta W_{nm}^{(j)} - \Delta W_{nm}'^{(j)}$ from the highest value to the lowest value for obtaining a sequence N' of L sorted indices n, the sequence N' comprising the $\eta$ locations where $Q_n^{(j)}$ is replaced by $Q_n'^{(j)}$ in the L+1 test vectors.

In particular, step A1.3 sorts $\Delta W_{nm}^{(j)} - \Delta W_{nm}'^{(j)}$ in increasing order, where $n \in N(m)$. Hence, the first values after the sorting are the ones with least difference between, the reliability of $Q_n^{(j)}$ and $Q_n'^{(j)}$ symbols. Finally, step A1.3 stores the sorted n indices in N.

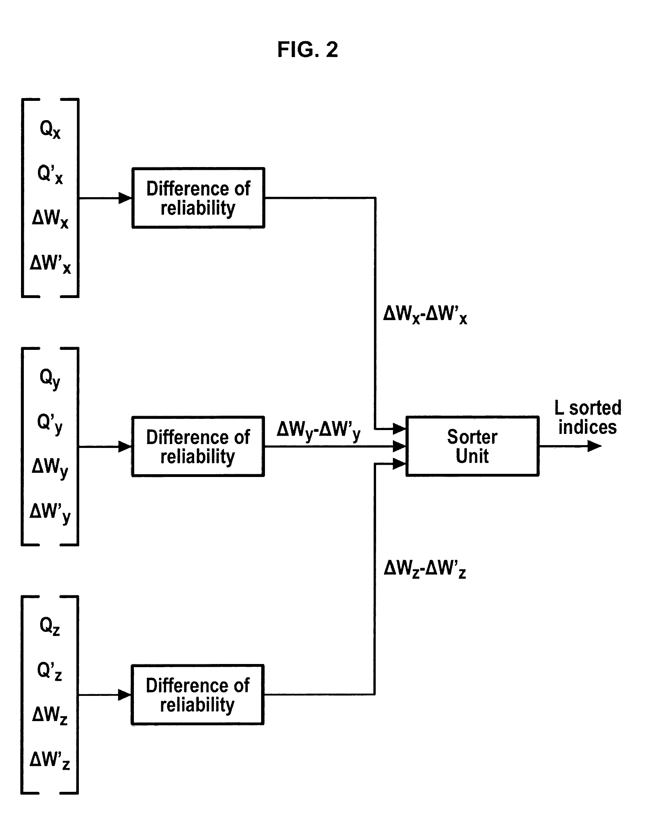

**Figure 2** illustrates the principles of step A1.3 for generating L sorted indices. On this figure, a check node is connected to three variable nodes x, y and z.

Additionally, each variable node is further configured for computing in steps A4.1 and A4.2 an intrinsic information $\mathbf{W}_{mn}^{(j)}$ from check node counting the votes of $R_n^{(j)}$ and of $R_n^{i(j)}$ with the respectively amplitude voting $v_0$, $v_1$.

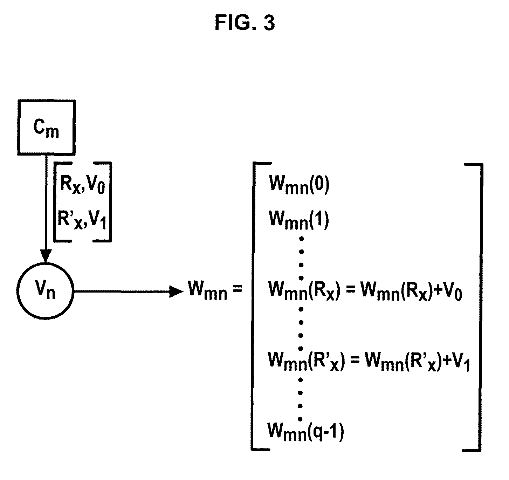

**Figure 3** illustrates the principles of steps A4.1 and A4.2 on which a variable node $V_n$ counts the vote in $W_{nm}$ according to the information received from a check node $C_m$. In this example, the count for the symbols are increased in $v_0$, and $v_1$ respectively.

Furthermore, each variable node taking as input the LLR vector and the vector $\mathbf{W}_{mn}^{(j)}$ combines (A4.1, A4.2) the previous vector $\mathbf{W}_{mn}^{(j-1)}$, the voting symbols $R_n^{0(j)}$ and of $R_n'^{(j)}$ and the voting amplitudes $v_0$, $v_1$ through a function $F_1$ for obtaining the vector defined as the intrinsic information $\mathbf{W}_{mn}^{(j)}$.

The function $F_1$ can be a simple summation of the values of the previous vector $\mathbf{W}_{mn}^{(j-1)}$ at indices indicated

by the voting symbols $R_n^{0(j)}$ and of $R_n^{i(j)}$ and the voting amplitudes $v_0$, $v_1$.

Also, each variable node taking as input the LLR vector and the $\mathbf{W}_n^{(j)}$ vector combines in steps A5.1, A5.2 the previous vector $\mathbf{W}_n^{(j-1)}$ $\mathbf{W}_{mn}^{(j-1)}$, the voting symbols $R_n^{(j)}$ and of $R_n'^{(j)}$ and the voting amplitudes $v_0$, $v_1$ through a function $F_2$ for obtaining the vector $\mathbf{W}_n^{(j)}$.

The function $F_2$ can be a simple summation of the values of the previous vector $\mathbf{W}_n^{(j-1)}$ at indices indicated by the voting symbols $R_n^{(j)}$ and of $R_n'^{(j)}$ and the voting amplitudes $v_0$, $v_1$.

Steps A2.1, A3.1, A4.1 and A5.1 from Algorithm 2 are the same as A2, A3, A4 and A5 in Algorithm 1. These steps are performed based on the most reliable symbols. Steps A2.2, A3.2, A4.2 and A5.2 are performed with the L test vectors from the considered set of $Q_n^{(j)}$ and $Q_n'^{(j)}$ symbols. Steps A2.2, A3.2, A4.2 and A5.2 are performed with the L+1 test vectors from the considered set of $Q_n^{(j)}$ and $Q_n'^{(j)}$ symbols. Step A2.2 performs the syndrome computation for the L+1 test vectors $(s_i')$, formed by one symbol $Q_{\mathcal{N}'}'^{(j)}$ and $d_c$ - 1 symbols $Q_n^{(j)}$. Step A3.2 calculates the candidates of the voting process, $R_{n-i}'^{(j)}$, according to each one if the L+1 test vectors. Steps A4.2 and A5.2 are similar to steps A4 and A5 of algorithm. The main difference is that in the first one the voted candidates are $R_{n-i}'^{(j)}$ instead of $R_n^{(j)}$. One can note that there are two amplitudes for the votes $v_0$, $v_1$. As it can been explained earlier, the constraint $v_0 > v_1$ must be fulfilled, because $R_n^{(j)}$ is computed with $Q_n^{(j)}$ symbols, so it is more reliable than $R_{n-i}'^{(j)}$, which is computed with both $Q_n^{(j)}$ and $Q_n'^{(j)}$ symbols.

<u>Architecture of a decoder for implementing the method of the invention</u>

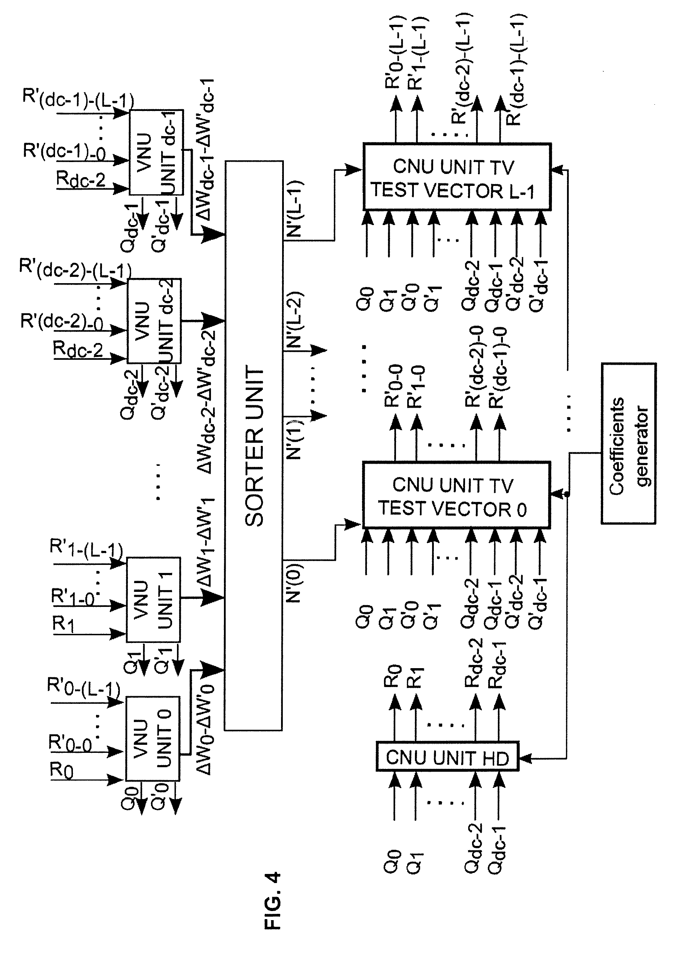

A decoder for implementing the method of the invention is now described in relation to **Figure 4.**

On this figure, a diagram of the complete architecture is described. Three main parts can be distinguished: i) VNU units, ii) CNU units and iii) the sorter unit. The decoder has dc VNU units. Each VNU unit computes $Q_n^{(j)}$ and $Q_n'^{(j)}$ symbols which are the input for CNU units, by using $R_n^{(j)}$ and $R_n'^{(j)}$ incoming symbols (with i from 0 to L). In addition, VNU units calculate $\Delta W_{nm}^{(j)}$ and $\Delta W_{nm}'^{(j)}$ and perform the subtraction $\left(\Delta W_{nm}^{(j)} - \Delta W_{nm}'^{(j)}\right)$, which is used as input of the sorter unit. So, VNU units implement steps A1.1, A1.2, A4.1, A4.2, A5.1 and A5.2 from Algorithm 2. The sorter unit receives dc $\Delta W_{nm}^{(j)} - \Delta W_{nm}'^{(j)}$ values and looks for the L smallest values (the elements which are added to the enlarged list are the ones with the smaller difference between the reliabilities of $Q_n^{(j)}$ and $Q_n'^{(j)}$). The sorter outputs are the indexes of the L elements with the smallest $\Delta W_{nm}^{(j)} - \Delta W_{nm}'^{(j)}$ values within the dc inputs. This part of the architecture implements step A1.3 and due to its complexity and relative novelty it is explained at the end of the section, separately from the rest. Finally, two different kinds of CNU units are found: the ones that compute only $Q_n^{(j)}$ symbols (CNU unit HD) and the ones that compute test vectors with both $Q_n^{(j)}$ and $Q_n'^{(j)}$ (CNU unit test vector (TV)). The decoder has just one CNU unit HD and L CNU units TV. Hardware resources for computing $h_{mn}$ coefficients are shared between both HD and TV units. CNU unit HD implements steps A2.1 and A3.1 steps, while the L CNU units TV implement steps A2.2 and A.3 from Algorithm 2.

<u>CNU units</u>

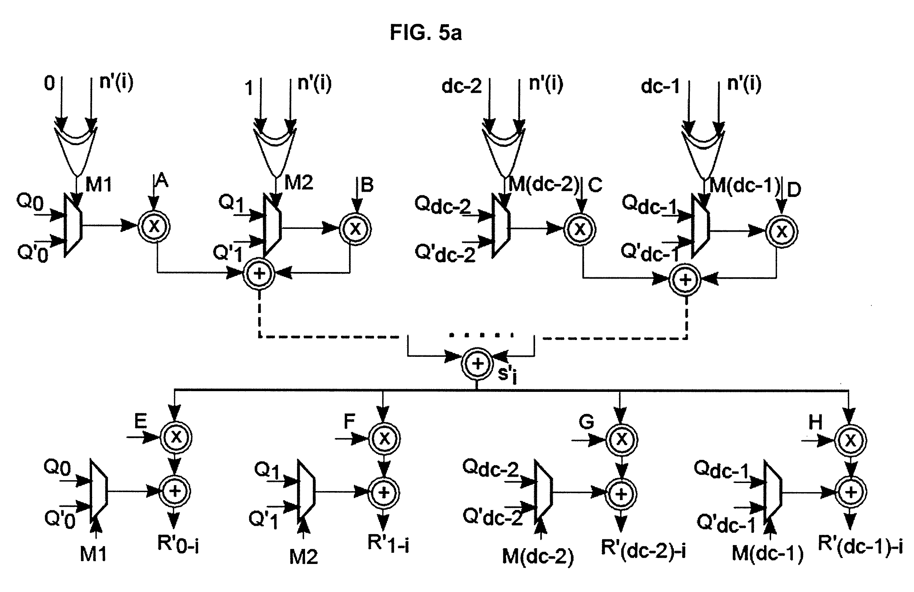

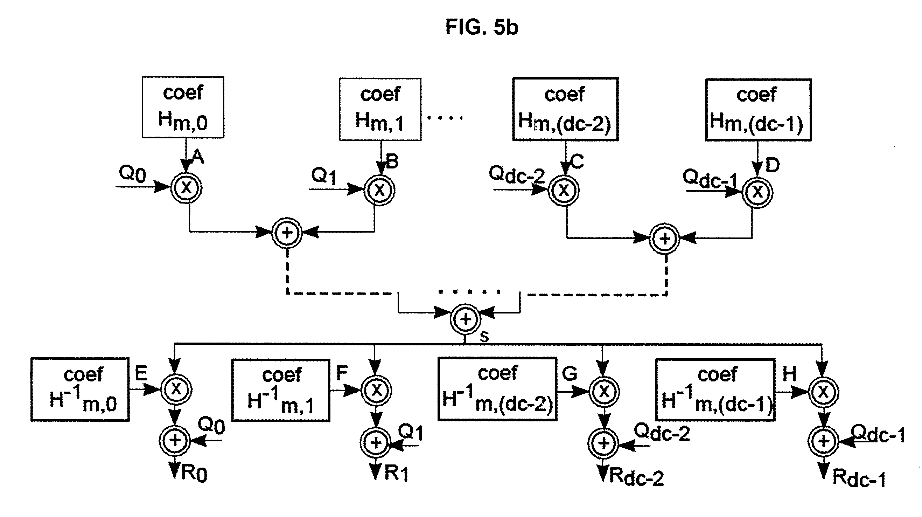

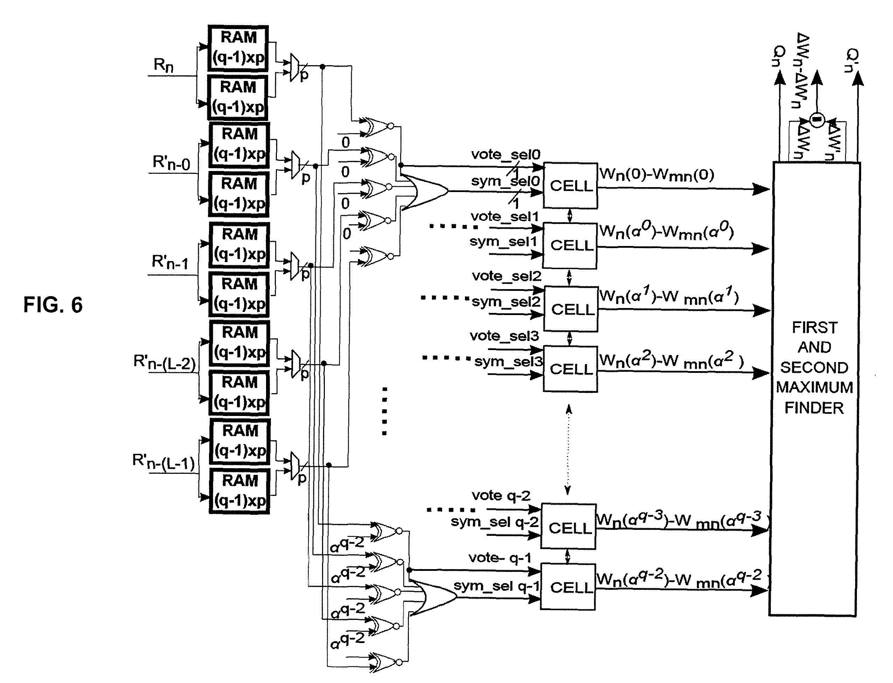

**Figure 5a** and **Figure 5b** illustrate an embodiment of the CNU units. All the arithmetic resources included in these units are defined over GF(q). Figure 6a includes the CNU unit HD, which is the same as the one applied in [18] for the ES-GBFDA architecture. The *coeff $H_{mn}$* and *coeff $H_{mn}'$* blocks generate in each clock cycle the coefficients $h_{mn}$

and $h'_{mn}$ required by steps A2.1, A2.2, A3.1 and A3.2. These blocks are implemented by two ROMs and one counter, which are not included in the figure for simplicity. The $h_{mn}$ coefficients are multiplies by the $Q_n^{(j)}$ inputs. The outputs of the multipliers are added using tree architecture, generating the hard decision syndrome $s$ (step A2.1). The syndrome $s$ is multiplied by $h_{mn}^{-1}$ coefficients and the result is added to $Q_n^{(i)}$ symbols to compute $R_n$ as indicated in step A3.1.

Figure 6b represents the CNU unit for a test vector $i$. This block performs the same arithmetic operations as the one in Figure 6a, the main difference is that not all the symbol inputs are the most reliable ones $\left(Q_n^{(j)}\right)$. To know in which of the dc possible locations $Q_n^{(j)}$ has to be changed by $Q_n'^{(j)}$, a comparison with the incoming $n'(i)$ index from the sorter unit must be done. The comparison is done by means of an XOR gate. If the index of a location is equal to $n'(i)$, the output of the XOR gate is zero and $Q_n'^{(j)}$ is with the multiplexor; in other case, $Q_n^{(j)}$ is selected. Note that L CNU units as the one in Figure 6b are necessary to implement steps A2.2 and A3.2 (to compute $s_i'$ and R'$_{n-i}$). Moreover, it is important to remark that the hardware resources for the generation of $h_{mn}$ and $h_{mn}^{-1}$ coefficients are shared between all the CNU units. In other words, just dc *coeff* $H_{mn}$ blocks and dc *coeff* $H_{mn}^{-1}$ blocks are needed in the whole decoder, and their outputs are wired to all the CNU units as illustrated on Figure 5.

*VNU units*

**Figure 6** illustrates an embodiment of a VNU unit. The VNU unit comprises four different parts: i) ping-pong memories, ii) logic for selecting the active cells, iii) VNU cells, and iv) first and second maximum finder logic.

Each VNU unit has 2 x (L + 1) RAMs that store $R_n^{(j)}$ and R'$_{n-i}$ symbols. A single RAM stores (q-1) $R_n^{(j)}$ (or R'$_{n-i}$) symbols that correspond to the information of one sub-matrix. $R_n^{(j)}$ and R'$_{n-i}$ symbols are represented with p bits because q=2$^p$. Memories connected to the same input work in a ping-pong way, so during q-1 clock cycles one RAM is read and the other is written and for the next q-1 cycles memories work in the opposite way. This reduces the idle cycles of the decoder and increases its efficiency.

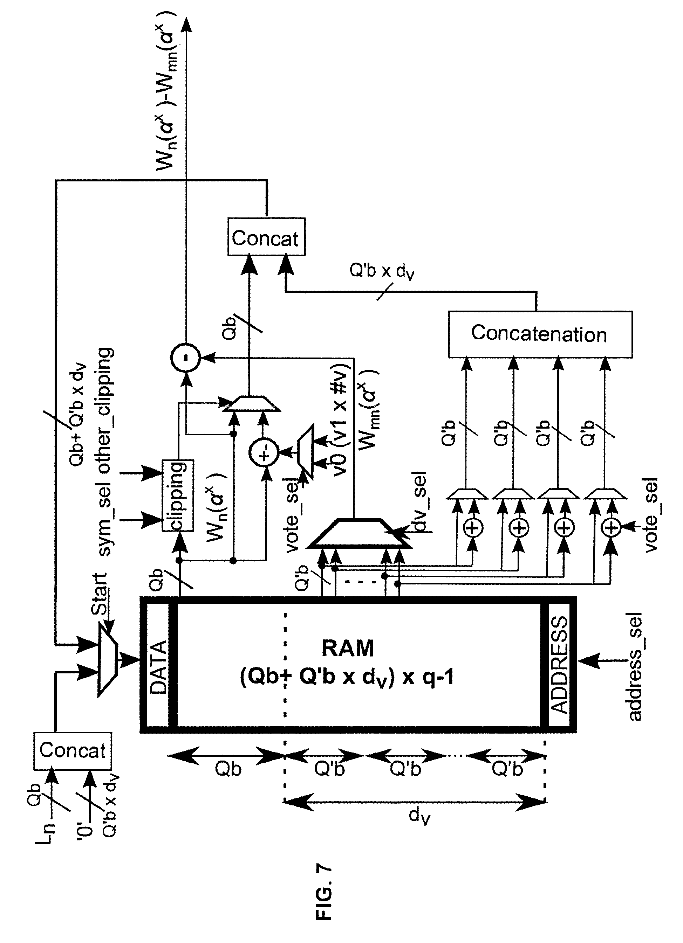

The logic for selecting the active cells generates *sym_sel x* which indicates if a VNU cell receives a vote or not. To compute *sym_sel x* of a cell $x$, all the $R_n^{(j)}$ and R'$_{n-i}$ symbols (outputs of the ping-pong RAMs selected by the multiplexor) are compared with the symbol x associated to the cell, where $x \in GF(q)$. These comparisons are implemented with XNOR gates, so if one of the symbols ($R_n^{(j)}$ or R'$_{n-i}$) is equal to $x$, the output of one of the XNOR gates will be one, indicating that the symbol $x$ is voted. *sym_sel x* is computed by applying the OR operation to all the XNOR outputs that are compared to the symbol $x$. All the outputs of the XNOR gates (A bit) connected to R'$_{n-i}$ are also added (omitted on Figure 7 for simplicity) to know the number of votes (#$v$) received from the enlarged list. In addition, the output of the XNOR gate connected to the most reliable candidate input $\left(R_n^{(j)}\right)$ is used as *vote_sel x.* To sum up the logic for the cells works as follows: i) if *vote_sel x* equals one and *sym_sel x* is also active, the vote is generated by $R_n^{(j)}$, so the amplitude $v_0$ is selected in the cell; ii) is *vote_sel x* equals zero but *sym_sel x* is active, the vote is generated by R'$_{n-i}$, so an amplitude proportional to $v_1$ ($v_1$ x #$v$) is selected in the cell; iii) otherwise, no vote is performed.

Each VNU unit has q cells that compute $W_n(0)$ - $W_{mn}(0)$, $W_n(\alpha^0)$ - $W_{mn}(\alpha^0)$, $|W_n(\alpha^1)-W_{mn}(\alpha^1)...,W_{mn}(\alpha^{q-1})-W_{mn}(\alpha^{q-2})|$.

In **Figure 7,** the architecture for one cell of the VNU unit is included. The number of bits for the quantization of $L_n$ and $W_n$ is $Q_b'$. The cell of the element $\alpha^x$ stores in each word of the RAM $W_n(a^x)$ and $W_{mn}(\alpha^x)$ for one value of n (and the $d_v$ values of check node $C_m$ connecred to this variable node $V_n$, so the length of the word is $Q_b + Q_b' \times d_v$. The memory has q-1 words because stores the information for q-1 different values of $n$. During initialization, the RAM is filled with the $L_n$ values concatened with $d_v \times Q_b'$ zeros. After that, the RAM stores the updated information for $W_n(\alpha^x)$ (steps A5.1 and A5.2) and the $d_v$ different values of $W_{mn}(\alpha^x)$ (steps A4.1 and A4.2). The update of $W_n(\alpha^x)$ depends on: i) the value of *sym_sel,* ii) the detection of clipping in other cells of the same VNU unit, iii) the detection of clipping in the own cell and iv) value of *vote_sel.* If the cell detects a vote (*sym_sel* is active) and no clipping is detected, in the own cell,

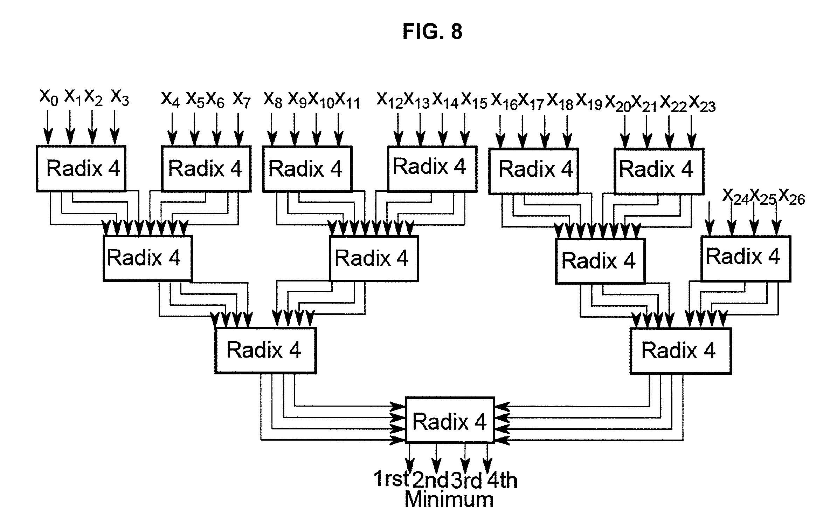

$W_n(a^x) = W_n(\alpha^x) + v_y$. If the cell does not detect a vote and clipping is detected in other cells, $W_n(\alpha^x) = W_n(\alpha^x) - v_y$. In other cases, $W_n(a^x)$ remains the same. $v_y$ can take two values: $v_0$ (step A4.1 and A5.1) or $v_1$ x #$v$ (step A4.2 and A5.2). A ROM with depth L stores the different $v_1$ x #$v$ possible values, in order to avoid a multiplier. The ROM is not included in Figure 8. On the other hand, the signal *dv_sel* selects the corresponding $W_{mn}(\alpha^x)$ from the $d_v$ possible values. $W_{mn}(\alpha^x)$ is required for the computation of $W_n(\alpha^x) - W_{mn}(\alpha^x)$. In addition, the $W_{mn}(\alpha^x)$ is increased by $v_y$ if *sym_sel*=1, to take into account the amplitude of the vote made in the current iteration (steps A4.1 and A4.2). Note that the symbols of the adders controlled by *vote_sel* in Figure 8 just a schematic way of representing an adder and a multiplexor controlled by *vote_sel* that selects $v_0$ or $v_1$ x #$v$. Both $W_n(a^x)$ and the $d_v W_{mn}(\alpha^x)$ updated values are concatenated and stored again in the RAM.

The outputs of q cells ($\mathbf{w}_n - \mathbf{w}_{mn}$) are the inputs of the maximum finder unit as it is shown in Figure 7. This block looks for: the first maximum ($\Delta W_n^{(j)}$ in step A1.1), the second maximum ($\Delta W_n'^{(j)}$ in step A1.2) and its associated GF symbols ($Q_n^{(j)}$ and $Q_n'^{(j)}$) between the q inputs. The architecture applied for this block can be found in [20]. Finally, $\Delta W_n^{(j)}$ and $\Delta W_n'^{(j)}$ outputs are subtracted to compute the difference between the highest and the second highest reliability values. The sorter unit (see Figure 5) generates L n'(i) indices for the L minimums between the $d_c$ outputs of the VNU units. This sorted will be explained below.

The latency equation for the whole decoder is the same as the one in [18]; however, if the same frequency wants to be reached the number of pipeline stages must be increased. The latency of the decoder is (q-1+*pipeline*) x $d_v$ x (#*iterations*+1) + (q-1+*pipeline*) clock cycles. Computing each sub-matrix takes ($2^q$-1) but the pipeline delay has to be added, so each sub-matrix needs (q-1+*pipeline*) clock cycles. As there are $d_v$ submatrices, each iteration needs (q-1+*pipeline*)x$d_v$ clock cycles. We have to add one extra iteration to the total number of iterations for the initialization and (q-1+*pipeline*) clock cycles are needed to get the values of the decoded codeword after the iterative process.

*Sorter unit: L-minimum finder in a dc element list*

The proposed ascendant sorter unit can be seen as an L-minimum finder. The architecture is based on the one from [20] but instead of looking for two minimums, it looks for L minimums. The main difference between this proposal and the one in [20] is that we do not apply masks to compute the minimums different from the absolute one. The fact of avoiding masks reduces the critical path at a cost of increasing some hardware resources. We describe an architecture for the sorter unit for L = 4 and dc = 27, but it can be easily generalized. In addition, the selection of the radix for each one of the stages is not optimized as the objective is just to show that there is a possible solution to implement the ascendant sorter unit with moderated area and continuous processing (each clock cycle a new group of elements can be sorted, after the latency generated by the pipeline with the first input).

**Figure 8** illustrates the architecture of a sorter unit according to an embodiment of the invention for the finder with L=4 and dc=27. As happens with the architecture in [20] for the two minimum finder, we distinguish two different kind of stages: I=0 and I>0. Stage I=0 units just involves L inputs, while I>0 computes 2 x L inputs.

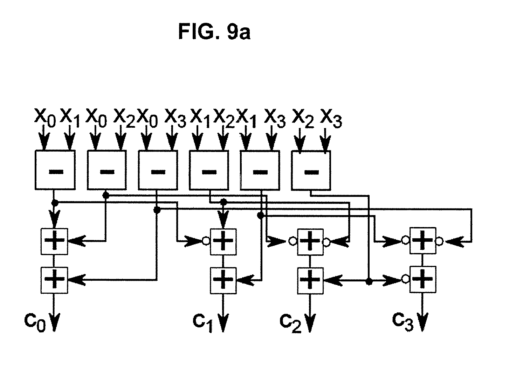

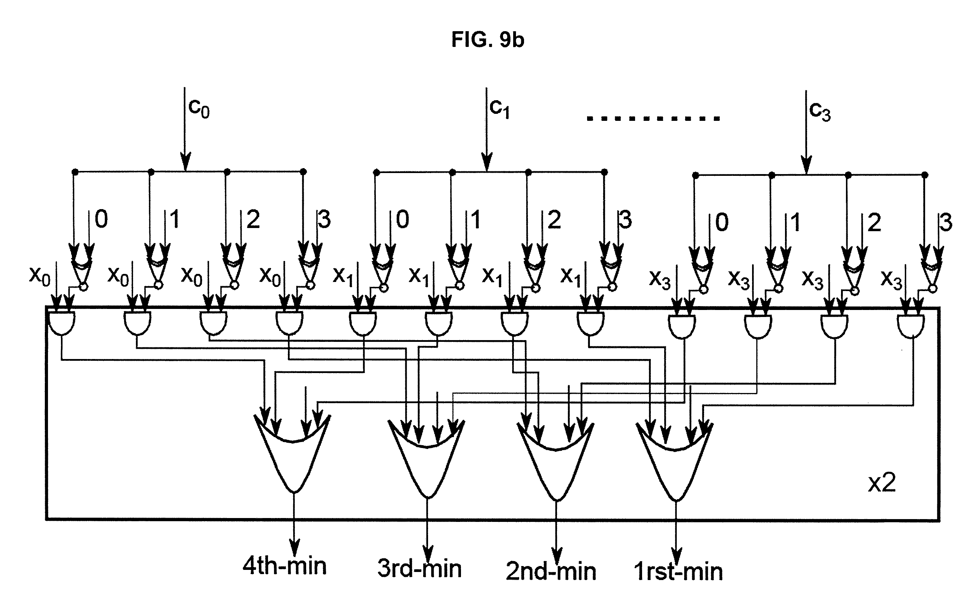

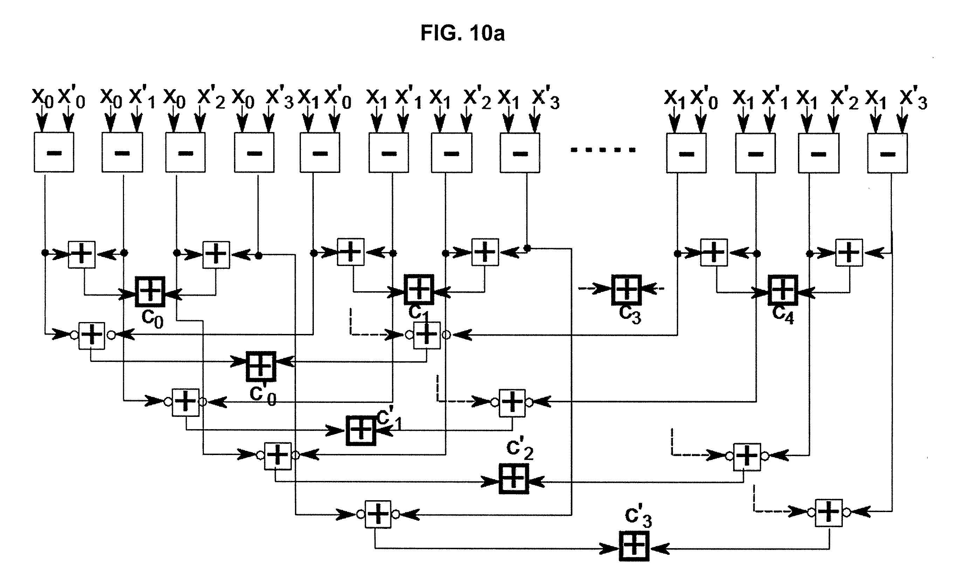

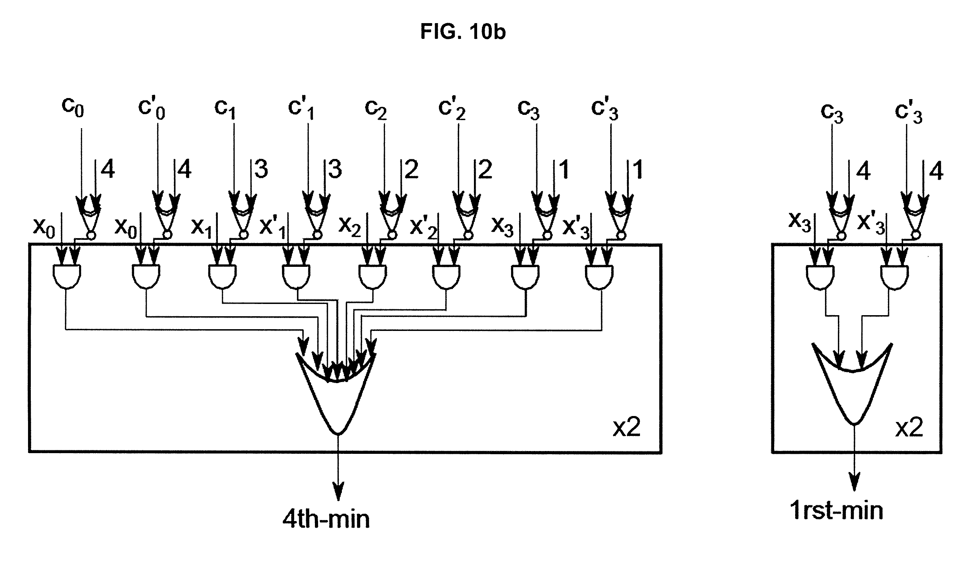

The architecture for one unit of stage I=0 is illustrated on **Figure 9a** and **Figure 9b.** First, comparisons between the L incoming values (xn) are performed (Figure 10a). The total number of comparisons that must be calculated are (L-1) x L, however, just (L-1) x L/2 are required to compute the comparisons, because the other (L-1) x L/2 values can be obtained by applying the complement to the output of the subtracters (performed by NOT gates). After the comparisons, the number of cases in which the input $x_n$ is a minimum is counted, $c_n$. For calculating each $c_n$, $log_2(L)$ adders are needed (for the case of L=4, two adders of two bits). The result of the count, $c_n$, is compared with all the possible solutions by means of XNOR gates (Figure 10b). As an example, if $c_0$ is the minimum compared to two elements in a list of four elements: the outputs of the XNOR gates whose input is connected to zero (is not the minimum) one (is minimum compared to one element) and three (is the absolute minimum) are zero; and the output of the XNOR gate whose input is two (minimum compared to two elements) is equal to one. So, the outputs of the XNOR gates with input $c_n$, will set just one AND gate output to $x_n$. Following the previous example, the AND gate connected to the XNOR with output equal one (the one compared with two), will have as result $x_0$; the rest of the AND gates (compared with zero, one and three) will have zero output. Finally, an OR operation is applied to the outputs of the AND gates connected to XNOR gates with the same constant input value. In Figure 10b, the output of the AND gates connected to XNOR gates whose constant input is equal to three are wired to the same OR gate, the one that computes the first minimum (because if the value is minimum compared to three elements in a list of four, the selected element will be the first minimum). The same reasoning can be followed for the rest of the minimums. Note that the AND and OR gates are duplicated (x2 in Figure 10b) because we need to output not just the sorted magnitude, but also the corresponding indexes.

The architecture for the units of stage I>0 is illustrated on **Figure 10.** In this case, there are 2 x L inputs, which can be seen as two L sorted sequences. The fact of having two groups of L elements already sorted reduces the number of required comparisons (from (2 x L) x (2 x L-1) to 2 x L$^2$), because comparisons between elements of the same group can be avoided. A total of L$^2$ substracters are required, because as happened with the unit of stage I=0 the other L$^2$ values are the complement of the ones computed by the subtractions. To count the number of comparisons ($c_n$ or $c'_n$) in which an input $x_n$ is less than the $x'_n$ elements (and vice versa) $\log_2(L+1)$ adders are required (for the case of L = 4, two adders of two bits and one adder of three bits are needed). As the elements inside each one of the two groups of inputs are sorted, some a priori information is known. For example, to compute the first minimum, just the first minimums of each group have to be taken into account and the one whose $c_n$ or $c'_n$ equals to L will be the absolute minimum. On contrary, for the L-th minimum all the incoming inputs should be take into account. Figure 10 includes an example of how to compute the L-th minimum for L = 4. The 4th minimum output can be: i) the 4th minimums of the input groups ($x_0$ and $x'_0$) with $c_0$ or $c'_0$ equal to 4 (which are minimum compared to the other entire group); ii) the 3$^{rd}$ minimums of the input groups ($x_1$ and $x'_1$) which are minimum compared to three of the elements of the other group ($c_1$ = 3 or $c'_1$ = 3); iii) the 2$^{nd}$ minimum of the input groups ($x_2$ and $x'_2$) which are minimum compared to two of the elements of the other group ($c_2$ = 2 or $c'_2$ = 2); or iv) the 1rst minimums ($x_3$ and $x'_3$) that are minimum compared to the 4$^{th}$ minimum of the other list ($c_3$ = 1 or $c'_3$ = 1). The computation and hardware resources for the rest of the minimums between the 1rst one and the L-th one can be derived easily generalizing the examples. AND and OR gates are duplicated to sort both magnitude and indexes.

In the invention, the decoder of Figure 5, the output of the n'(i) indexes are required to elaborate the test vectors. With the proposed architecture, the computation of the n'(i) indexes are done in parallel avoiding recursive solutions that would increase considerably the number of clock cycles per iteration of the decoder.

Implementation results and comparison

We here below give estimated results of area and throughput for the decoder architecture described above.

To perform the estimation, analytical methods as the ones in [21] were applied. To ensure that a fair comparison with other works is done, we overestimate some hardware resources to provide an upper bound in both area and critical path. For example, the area of the first and second maximum finder in Figure 7 was considered the same as the area for the L-minimum finder with L = 4. For comparison proposals, a (837,726) code, with quasicyclic matrix **H**$_{K=124,N=837}$ over a field GF(q) with q=32, $d_c$ = 27 and $d_v$ = 4 was considered. The quantization scheme applied to Algorithm 2 is $Q_b$ = 7 and $Q'_b$ = 5. Note that as the optimized amplitudes for the votes of this code are $v_0$ = 0.5 and $v_1$ = 0.25 two extra bits are required compared to ES-GBFDA, which works just with integer vote amplitudes and cannot differentiate soft decision in the votes (all the votes have the same amplitude).

On the other hand, the MV-SF architecture adds hardware to compute the test vectors, increasing the length of the critical path compared to ES-GBFDA in [18]. The number of gates of the critical path is increased at the check node for the selection of the test vectors (Figure 4b) and at the sorter unit (Figure 9). Hence, to achieve a similar frequency to the ES-GBFDA architecture [18] it is necessary to double the number of pipeline stages (pipeline=10). Four extra pipeline stages at the sorter unit and one extra pipeline stage at the check node are necessary to keep the critical path equal to 22 gates.

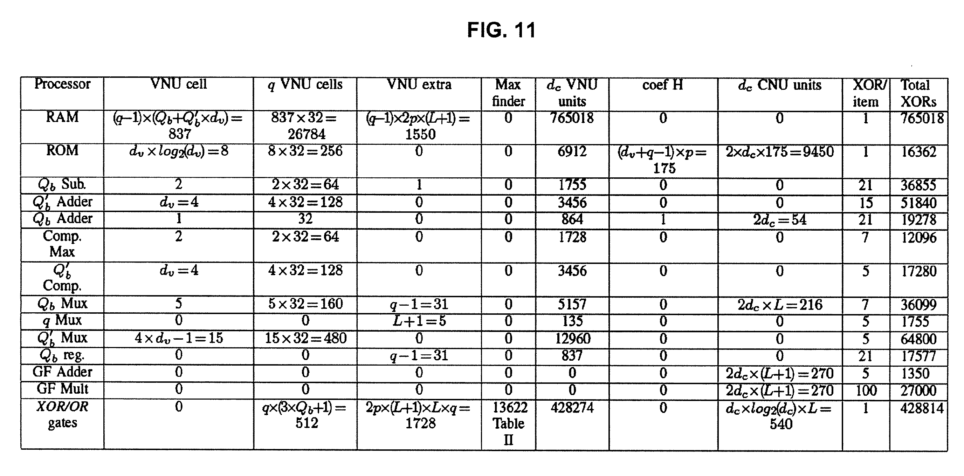

Although this critical path is two gates longer than the one in [18], the effect of routing is bigger than the one from the logic depth, so we can assume frequency ~238MHz without introducing a big error in the estimation. Hardware resources for MV-SF decoder with the previous parameters can be found in the table of **Figure 11.**

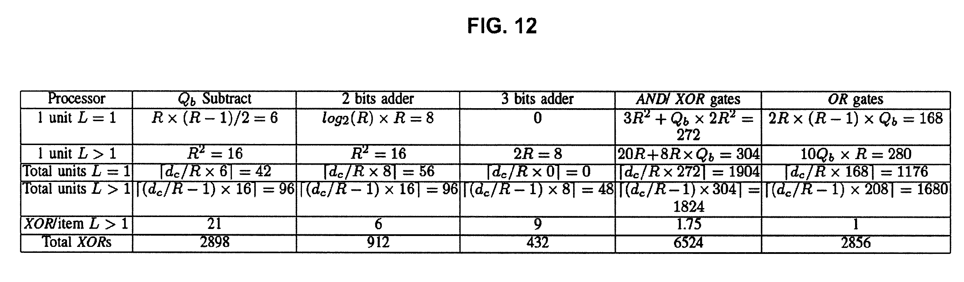

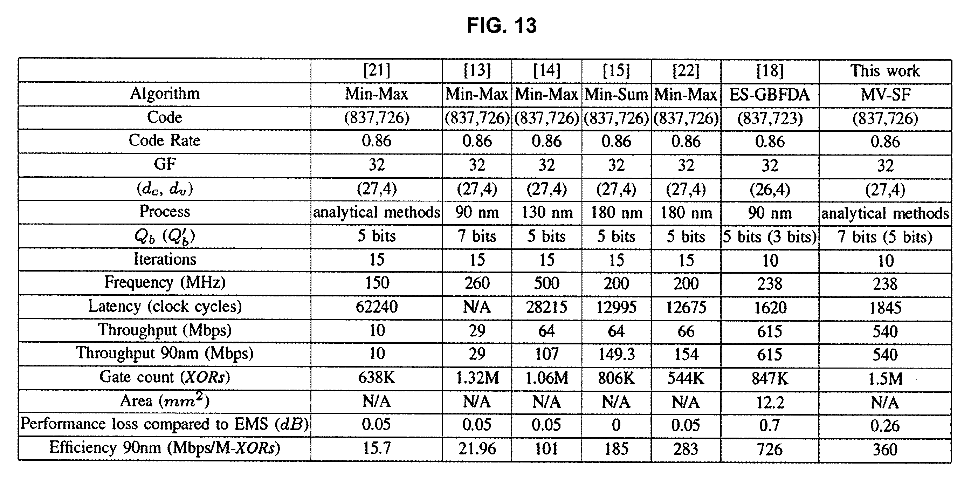

In the table of **Figure 12,** results for NB-LDPC architectures based on different algorithms, including the one in this paper, are summarized. Note that all the codes in table of **Figure 13** have the same sizes, i.e. same number of coded symbols N = 837, and same number of non-binary parity check equations M = 124. The code used for the ES-GBFDA [18] has 3 more redundant rows than the other code. It is important to remark that as different algorithms are implemented in each reference, different coding gains are obtained by each decoder. For this reason, we also include the performance loss of each one of the decoders, taking as reference the performance of EMS. Performance degradation in coding gain is difficult to take into account in the efficiency parameter, so it is not included. The efficiency parameter is computed as *throughput(Mbps)=area(MXORS),* following the description of efficiency from [13] and [14], [15].

Comparing the ES-GBFDA decoder to the one for implementing the method of the invention, we increase area 1.5M/847K=1.77 times with an slightly lower throughput (540Mbps instead of 615Mbps).

The decoder of Algorithm 2 is 726/360 = 2 times less efficient than the one based on ES-GBFDA in [18] but it reaches a non-negligible coding gain of 0.44dB. A direct mapping architecture of Algorithm 2 requires L + 1 times the area of ES-GBFDA (L for the less reliable test vectors and one for the most reliable one), which is 4.23MXOR. Hence, our proposal is 4.23M/1.5M = 2.82 times less area consuming than a direct mapping architecture with 12% less throughput. In terms of efficiency, a direct mapping architecture 615Mbps=4.23MXORs= 145) is more than two times less efficient that the proposal of this work, with the same coding gain.

**EP 2 903 166 A1**

To the best knowledge of the authors, the architecture in [15] is the most efficient one based on Min-Sum algorithm.

Compared to this architecture, the decoder of the invention requires 1.5M/806K = 1.86 times more area, but reaches a throughput 540/149 = 3.62 times higher. The decoder for Algorithm 2 is 360=185 = 1.9 times more efficient compared to the one in [15] based on Simplified Min-Sum, but a difference of 0.26dB in coding gain should be taken into account. Regarding to Min-Max architectures, we compare to the most efficient one, [22] (other efficient architectures are included in the table of Figure 14. The architecture based on Min-Max proposed in [22] is 1.5M/0.54M = 2.75 times smaller than the one introduced in this paper. However, our proposal reaches a throughput 540/154 = 3.5 times higher than the Min-Max decoder in [22]. In terms of efficiency, the architecture based on Algorithm 2 shows 27% efficiency gain compared to the one based on Min-Max, at the cost of 0.21 dB of performance loss.

To sum up, the architecture based the method of the invention has 1.86 and 2.75 times more area than the ones based on EMS or Min-Max, but reaches a throughput 3.5 times higher. MV-SF introduces 0.26dB of performance loss compared to EMS and 0.21dB compared to Min-Max.

References

[1] M. Davey and D. J. MacKay, "Low density parity check codes over GF(q)", IEEE Commun. Letter, vol. 2, pp. 165-167, Jun. 1998.

[2] L. Barnault and D. Declercq, "Fast decoding algorithm for LDPC over GF(2q)", Proc. Info. Theory Workshop, pp. 70-73, Paris, France, Mar. 2003.

[3] H. Wymeersch, H. Steendam and M. Moeneclaey, "Log-domain decoding of LDPC codes over GF(q)," Proc. IEEE Intl. Conf. on Commun., pp. 772-776, Paris, France, Jun. 2004.

[4] C. Spagnol, E. Popovici and W. Marnane, "Hardware implementation of GF(2m) LDPC decoders", IEEE Trans. on Circuits and Syst.-I, vol. 56, no. 12, pp. 2609-2620, Dec. 2009.

[5] D. Declercq and M. Fossorier, "Decoding algorithms for nonbinary LDPC codes over GF(q), "IEEE Trans. on Commun., vol. 55, pp. 633-643, Apr 2007.

[6] C. Poulliat, M. Fossorier and D. Declercq, "Design of regular (2,dc)- LDPC codes over GF(q) using their binary images", IEEE Trans. Commun., vol. 56(10), pp. 1626 - 1635, October 2008.

[7] V. Savin, "Min-max decoding for non binary LDPC codes," Proc. IEEE ISIT, pp. 960-964, Toronto, Canada, July 2008.

[8] A. Voicila, D. Declercq, F. Verdier, M. Fossorier and P. Urard, "Low- Complexity Decoding for non-binary LDPC Codes in High Order Fields", IEEE Trans. on Commun., vol. 58(5), pp 1365-1375, May 2010.

[9] E. Boutillon and L. Conde-Canencia, "Bubble check: a simplified algo- rithm for elementary check node processing in extended min-sum non- binary LDPC decoders," Electronics Letters, vol. 46, pp. 633-634, April 2010.

[10] X. Zhang and F. Cai, "Partial-parallel decoder architecture for quasi- cyclic non-binary LDPC codes," Proc. of Acoustics Speech and Signal Processing (ICASSP), pp. 1506-1509, Dallas, Texas, USA, March 2010.

[11] D. Zhao, X. Ma, C. Chen, and B. Bai, "A Low Complexity Decoding Algorithm for Majority-Logic Decodable Nonbinary LDPC Codes," IEEE Commun. Letters, vol. 14, no. 11, pp. 1062-1064, Nov. 2010.

[12] C. Chen, B. Bai, X. Wang, and M. Xu, "Nonbinary LDPC Codes Con- structed Based on a Cyclic MDS Code and a Low-Complexity Nonbinary Message-Passing Decoding Algorithm," IEEE Commun. Letters, vol. 14, no. 3, pp. 239-241, March 2010.

[13] Y.-L. Ueng, C.-Y. Leong, C.-J. Yang, C.-C. Cheng, K.-H. Liao, and S.- W. Chen, "An efficient layered decoding architecture for nonbinary QC- LDPC codes," IEEE Trans. on Circuits and Systems I: Regular Papers, vol. 59, no. 2, pp. 385-398, Feb. 2012.

[14] J. Lin and Z. Yan, "Efficient shuffled decoder architecture for nonbinary quasicyclic LDPC codes," IEEE Trans. on Very Large Scale Integration (VLSI) Systems, vol. PP, no. 99, p. 1, 2012.

[15] X. Chen and C.-L. Wang, "High-throughput efficient non-binary LDPC decoder based on the Simplified Min- Sum algorithm," IEEE Trans. On Circuits and Systems I: Regular Papers, vol. 59, no. 11, pp. 2784-2794, Nov. 2012.

[16] X. Zhang, F. Cai and S. Lin, "Low-Complexity Reliability-Based Message-Passing Decoder Architectures for Non-Binary LDPC Codes," IEEE Trans. on Very Large Scale Integration (VLSI) Systems, vol. 20, no. 11, pp. 1938-1950, Sept. 2011.

[17] F. Garcia-Herrero, M. J. Canet and J. Valls, "Architecture of generalized bit-flipping decoding for high-rate non-binary LDPC codes," Springer Circuits, Systems, and Signal Processing, vol. 32, no. 2, pp. 727-741, April 2013.

[18] F. Garcia-Herrero, M.J. Canet, J. Valls, "Decoder for an Enhanced Serial Generalized Bit Flipping Algorithm," IEEE International Conference on Electronics, Circuits and Systems (ICECS), pp. 412-415, Sevilla, Spain, Dec. 2012.

[19] B. Zhou, J. Kang, S. Song, S. Lin, K. Abdel-Ghaffar, and M. Xu, "Construction of non-binary quasi-cyclic LDPC codes by arrays and array dispersions," IEEE Trans. on Commun., vol. 57, no. 6, pp. 1652-1662, June 2009.

[20] L. Amaru, M. Martina, and G. Masera, "High speed architectures for finding the first two maximum/minimum values," IEEE Trans. on Very Large Scale Integration (VLSI) Systems, vol. 20, no. 12, pp. 2342-2346, Dec. 2012.
[21] X. Zhang and F. Cai, "Reduced-complexity decoder architecture for nonbinary LDPC codes," IEEE Trans. on Very Large Scale Integration (VLSI) Systems, vol. 19, no. 7, pp. 1229-1238, July 2011.
[22] F. Cai; X. Zhang, "Relaxed Min-Max Decoder Architectures for Nonbinary Low-Density Parity Check Codes," IEEE Transactions on Very Large Scale Integration (VLSI) Systems, 2013.
[23] F. Garcia-Herrero, D. Declercq, J. Valls, "Non-Binary LDPC Decoder based on Symbol Flipping with Multiple Votes," submitted to IEEE Commun. Letters, 2013.

## Claims

1. A method for decoding a non-binary low density parity-check (NB-LDPC) code defined in a finite field of size q, the code can be displayed in a bipartite graph comprising at least one variable node $V_n$, $n = 0, ..., N - 1$ and at least one check node $C_m$, $m = 0, ..., M - 1$, said method comprising for each iteration $j$ of $I_t$ decoding iterations, the steps consisting in that:

   each variable node $V_n$, connected to a check node $C_m$, is configured for determining (A1.1, A1.2) a most reliable symbols $Q_n^{1(j)}$ and at least one symbol which is at least a $p^{th}$ most reliable symbol $Q_n^{p(j)}$, with $p \geq 2$ for obtaining a vector of dc most reliable symbols;
   each check node $C_m$ is configured for determining:

   (A3.1) a first symbol to be voted $R_n^{0(j)} = R_n^{(j)}$ based on the vector of $d_c$ most reliable symbols passed by the variable nodes connected to him in the bipartite graph;

   (A3.2) a list of i = 1, ..., $L$ second symbol to be voted $R_n^{i(j)}$ based on a list of L+1test vectors defined as a combination of $d_c$ symbols with a restriction according to which at most $\eta$ of these $d_c$ symbols are a $p^{th}$ most reliable symbol $Q_n^{p(j)}$ with $p \geq 2$, and at least $d_c$-$\eta$ of these $d_c$ symbols are a most reliable symbol $Q_n^{1(j)}$.

2. The method according to Claim 1, wherein each variable node is configured for determining (A1.1, A1.2) the most reliable symbols $Q_n^{(j)}$ and the second most reliable symbol $Q_n^{2(j)} = Q_n^{'(j)}$ and their corresponding extrinsic reliability $\Delta W_n^{(j)}$, $\Delta W_n^{'(j)}$ so that at a check node (A2.1, A2.2) the list of L+1 test vectors are built by replacing symbol $Q_n^{(j)}$ by the second most reliable symbol $Q_n^{'(j)}$ in at most $\eta \leq L$ locations were the differences between $\Delta W_n^{(j)}$ and $\Delta W_n^{'(j)}$ are the smallest.

3. The method according to the preceding claim, wherein $\eta \leq L$, the method comprising a step consisting in that a sorter unit is configured for sorting (A1.3) the differences of extrinsic reliability $\Delta W_{nm}^{(j)} - \Delta W_{nm}^{2(j)}$ from the highest value to the lowest value for obtaining a sequence $\mathcal{N}'$ of $L$ sorted indices n, the sequence $\mathcal{N}'$ comprising the $\eta$ locations where $Q_n^{(j)}$ is replaced by $Q_n^{2(j)}$ in the L+1 test vectors.

4. The method according to claims 1 to 3, wherein each variable node is further configured for computing (A4.1, A4.2) an intrinsic information $W_{mn}^{(j)}$ from check node counting the votes of $R_n^{0(j)}$ and $R_n^{i(j)}$ with the respectively amplitude voting $v_0$, $v_2$.

5. The method according to claims 1 to 4, comprising before the $I_t$ decoding iterations an initialization step (Initialization) comprising the sub-steps of:

   determining a LLR vector $L_n = (L_n[0], L_n[1],..., L_n[q - 1])$ of a $n^{th}$ symbol in a sequence of $N$ non-binary noisy symbols;
   initializing a vector of APP vectors $W_n^{(0)}$ to the LLR vector $L_n$ and initializing a matrix $W_{mn}^{(0)}$ to an all-zero matrix,

said matrix $\mathbf{W}_{mn}^{(j)}$ being the intrinsic information from the check node m.

6. The method according to the preceding claim, wherein each variable node taking as input the LLR vector and the vector $\mathbf{W}_{mn}^{(j)}$ combines (A4.1, A4.2) the previous vector $\mathbf{W}_{mn}^{(j-1)}$, the voting symbols $R_n^{0(j)}$ and $R_n'^{(j)}$ and the voting amplitudes $v_0$, $v_1$ through a function $F_1$ for obtaining the vector defined as the intrinsic information $\mathbf{W}_{mn}^{(j)}$.

7. The method according to the preceding claim, wherein the function $F_1$ is a simple summation of the values of the previous vector $\mathbf{W}_{mn}^{(j-1)}$ at indices indicated by the voting symbols $R_n^{0(j)}$ and $R_n^{i(j)}$ and the voting amplitudes $v_0$, $v_1$.

8. The method according to Claim 5, wherein each variable node taking as input the LLR vector and the vector $\mathbf{W}_n^{(j)}$ combines (A5.1, A5.2) the previous vector $\mathbf{W}_n^{(j-1)}$ $\mathbf{W}_{mn}^{(j-1)}$, the voting symbols $R_n^{0(j)}$ and $R_n^{i(j)}$ and the voting amplitudes $v_0$, $v_1$ through a function $F_2$ for obtaining the vector $\mathbf{W}_n^{(j)}$.

9. The method according to the preceding claim, wherein the function $F_2$ is a simple summation of the values of the previous vector $\mathbf{W}_n^{(j-1)}$ at indices indicated by the voting symbols $R_n^{0(j)}$ and $R_n^{i(j)}$ and the voting amplitudes $v_0$, $v_1$.

10. A decoding apparatus comprising at least one variable node $V_n$ and a at least one check node $C_m$, said decoder being configured for implementing a method for decoding a non-binary low density parity-check (NB-LDPC) code defined in a finite field of size q, according to one of the preceding claims.

11. A decoding apparatus according to the preceding claim, said apparatus being configured for implementing check node operations by means of L processing units configured dynamically to compute $R_n^{i(j)}$, with $i = 1,..., L$, each one of the L processing units share $3xd_c$ inputs that correspond to the symbols $Q_n^{1(j)}, Q_n^{2(j)}$ and to the coefficients of the code, said inputs of each processing unit are combined by means of $2xd_c$ GF multipliers and $2xd_c$ GF adders, said processing units including all the logic necessary to compute L different syndromes as an intermediate step and a variable number of pipeline stages that may vary from 0 to $log2(d_c) + 2$ depending on the speed of said processing unit.

12. A decoding apparatus according to the preceding claim, said apparatus being configured for implementing the method of claims 6, 7, 8 and 9 and comprising: i) a bank of memories that store $R_n^{i(j)}$, with $i = 0, ..., L$ symbols, ii) q processors with a logic required to compare the symbols $R_n^{i(j)}$, with $i = 0, ..., L$, with the q elements of the Galois Field and determine the amplitude of the votes corresponding to that symbols; and iii) q cells that implement functions $F_1$ and $F_2$, the bank of memories being implemented with L RAM memories or a bank of L registers., the processors being implemented with L-XNOR gates of $log2(q)$ bits and L-OR gates of 1 bit to compare the input symbols, i.e., symbols $R_n^{i(j)}$, with $i = 0, ..., L-1$, with the q Galois Field elements and determine the amplitude of the votes, the cells including a logic necessary for implementing $F_1$ and $F_2$ and the storage resources for $\mathbf{W}_{mn}^{(j)}$ and $\mathbf{W}_n^{(j)}$.

13. A decoding apparatus according to Claim 11, said apparatus comprising a sorter unit configured for obtaining the sequence $\mathcal{N}$ of L sorted indices n according to the method defined in Claim 3, the sorter unit including at least one sub-processors of radix L, each sub-processor including: i) one stage of comparators configured for performing all the possible combinations of the inputs; ii) a plurality of adders and a plurality of NOT gates configured for computing a summation of the output signals of the different comparators associated to the same input, the adders being configured for checking how many times a condition of greater than or less than is satisfied for each one of the inputs; iv) a plurality of logic gates configured for implementing a L different masks that allows ordering the inputs according to the information provided by the outputs of the adders, logic gates are XNOR, OR and AND gates.

## FIG. 1a

## FIG. 1b

## FIG. 1c

$C_m$

$dC$

$V_x$ $V_y$ $\cdots\cdots$ $V_z$

$$\begin{bmatrix} Q_x \\ Q^2_x \\ Q^3_x \\ \vdots \\ Q^p_x \end{bmatrix} \begin{bmatrix} Q_y \\ Q^2_y \\ Q^3_y \\ \vdots \\ Q^p_y \end{bmatrix} \cdots\cdots \begin{bmatrix} Q_z \\ Q^2_z \\ Q^3_z \\ \vdots \\ Q^p_z \end{bmatrix}$$

## FIG. 1d

$C_m$

$dC$

$V_x$ $V_y$ $\cdots\cdots$ $V_z$

$$\begin{bmatrix} R_x \\ R^2_x \\ R^3_x \\ \vdots \\ R^p_x \end{bmatrix} \begin{bmatrix} R_y \\ R^2_y \\ R^3_y \\ \vdots \\ R^p_y \end{bmatrix} \cdots\cdots \begin{bmatrix} R_z \\ R^2_z \\ R^3_z \\ \vdots \\ R^p_z \end{bmatrix}$$

# FIG. 2

# FIG. 3

$$C_m$$

$$\begin{bmatrix} R_x, V_0 \\ R'_x, V_1 \end{bmatrix}$$

$$V_n$$

$$W_{mn} = \begin{bmatrix} W_{mn}(0) \\ W_{mn}(1) \\ \vdots \\ W_{mn}(R_x) = W_{mn}(R_x) + V_0 \\ \vdots \\ W_{mn}(R'_x) = W_{mn}(R'_x) + V_1 \\ \vdots \\ W_{mn}(q-1) \end{bmatrix}$$

FIG. 4

## FIG. 5a

EP 2 903 166 A1

FIG. 5b

EP 2 903 166 A1

FIG. 6

FIG. 7

FIG. 8

1rst 2nd 3rd 4th
Minimum

EP 2 903 166 A1

FIG. 9a

FIG. 9b

FIG. 10a

EP 2 903 166 A1

FIG. 10b

4th-min

1rst-min

EP 2 903 166 A1

FIG. 11

| Processor | VNU cell | $q$ VNU cells | VNU extra | Max finder | $d_c$ VNU units | coef H | $d_c$ CNU units | XOR/item | Total XORs |
|---|---|---|---|---|---|---|---|---|---|
| RAM | $(q-1)\times(Q_b+Q_b'\times d_v)=$ 837 | $837\times32=$ 26784 | $(q-1)\times2p\times(L+1)=$ 1550 | 0 | 765018 | 0 | 0 | 1 | 765018 |
| ROM | $d_v\times log_2(d_v)=8$ | $8\times32=256$ | 0 | 0 | 6912 | $(d_v+q-1)\times p=$ 175 | $2\times d_c\times175=9450$ | 1 | 16362 |
| $Q_b$ Sub. | 2 | $2\times32=64$ | 1 | 0 | 1755 | 0 | 0 | 21 | 36855 |
| $Q_b'$ Adder | $d_v=4$ | $4\times32=128$ | 0 | 0 | 3456 | 0 | 0 | 15 | 51840 |
| $Q_b$ Adder | 1 | 32 | 0 | 0 | 864 | 1 | $2d_c=54$ | 21 | 19278 |
| Comp. Max | 2 | $2\times32=64$ | 0 | 0 | 1728 | 0 | 0 | 7 | 12096 |
| $Q_b'$ Comp. | $d_v=4$ | $4\times32=128$ | 0 | 0 | 3456 | 0 | 0 | 5 | 17280 |
| $Q_b$ Mux | 5 | $5\times32=160$ | $q-1=31$ | 0 | 5157 | 0 | $2d_c\times L=216$ | 7 | 36099 |
| $q$ Mux | 0 | 0 | $L+1=5$ | 0 | 135 | 0 | 0 | 5 | 1755 |
| $Q_b'$ Mux | $4\times d_v-1=15$ | $15\times32=480$ | 0 | 0 | 12960 | 0 | 0 | 5 | 64800 |
| $Q_b$ reg. | 0 | 0 | $q-1=31$ | 0 | 837 | 0 | 0 | 21 | 17577 |
| GF Adder | 0 | 0 | 0 | 0 | 0 | 0 | $2d_c\times(L+1)=270$ | 5 | 1350 |
| GF Mult | 0 | 0 | 0 | 0 | 0 | 0 | $2d_c\times(L+1)=270$ | 100 | 27000 |
| XOR/OR gates | 0 | $q\times(3\times Q_b+1)=$ 512 | $2p\times(L+1)\times L\times q=$ 1728 | 13622 Table II | 428274 | 0 | $d_c\times log_2(d_c)\times L=$ 540 | 1 | 428814 |

EP 2 903 166 A1

## FIG. 12

| Processor | $Q_b$ Subtract | 2 bits adder | 3 bits adder | AND/ XOR gates | OR gates |
|---|---|---|---|---|---|
| 1 unit $L = 1$ | $R \times (R-1)/2 = 6$ | $log_2(R) \times R = 8$ | 0 | $3R^2 + Q_b \times 2R^2 = 272$ | $2R \times (R-1) \times Q_b = 168$ |
| 1 unit $L > 1$ | $R^2 = 16$ | $R^2 = 16$ | $2R = 8$ | $20R + 8R \times Q_b = 304$ | $10Q_b \times R = 280$ |
| Total units $L = 1$ | $\lceil d_c/R \times 6 \rceil = 42$ | $\lceil d_c/R \times 8 \rceil = 56$ | $\lceil d_c/R \times 0 \rceil = 0$ | $\lceil d_c/R \times 272 \rceil = 1904$ | $\lceil d_c/R \times 168 \rceil = 1176$ |
| Total units $L > 1$ | $\lceil (d_c/R - 1) \times 16 \rceil = 96$ | $\lceil (d_c/R - 1) \times 16 \rceil = 96$ | $\lceil (d_c/R - 1) \times 8 \rceil = 48$ | $\lceil (d_c/R - 1) \times 304 \rceil = 1824$ | $\lceil (d_c/R - 1) \times 208 \rceil = 1680$ |
| XOR/item $L > 1$ | 21 | 6 | 9 | 1.75 | 1 |
| Total XORs | 2898 | 912 | 432 | 6524 | 2856 |

33

# FIG. 13

| | [21] | [13] | [14] | [15] | [22] | [18] | This work |
|---|---|---|---|---|---|---|---|
| Algorithm | Min-Max | Min-Max | Min-Max | Min-Sum | Min-Max | ES-GBFDA | MV-SF |
| Code | (837,726) | (837,726) | (837,726) | (837,726) | (837,726) | (837,723) | (837,726) |
| Code Rate | 0.86 | 0.86 | 0.86 | 0.86 | 0.86 | 0.86 | 0.86 |
| GF | 32 | 32 | 32 | 32 | 32 | 32 | 32 |
| $(d_c, d_v)$ | (27,4) | (27,4) | (27,4) | (27,4) | (27,4) | (26,4) | (27,4) |
| Process | analytical methods | 90 nm | 130 nm | 180 nm | 180 nm | 90 nm | analytical methods |
| $Q_b$ $(Q'_b)$ | 5 bits | 7 bits | 5 bits | 5 bits | 5 bits | 5 bits (3 bits) | 7 bits (5 bits) |
| Iterations | 15 | 15 | 15 | 15 | 15 | 10 | 10 |
| Frequency (MHz) | 150 | 260 | 500 | 200 | 200 | 238 | 238 |
| Latency (clock cycles) | 62240 | N/A | 28215 | 12995 | 12675 | 1620 | 1845 |
| Throughput (Mbps) | 10 | 29 | 64 | 64 | 66 | 615 | 540 |
| Throughput 90nm (Mbps) | 10 | 29 | 107 | 149.3 | 154 | 615 | 540 |
| Gate count ($XORs$) | 638K | 1.32M | 1.06M | 806K | 544K | 847K | 1.5M |
| Area ($mm^2$) | N/A | N/A | N/A | N/A | N/A | 12.2 | N/A |
| Performance loss compared to EMS ($dB$) | 0.05 | 0.05 | 0.05 | 0 | 0.05 | 0.7 | 0.26 |
| Efficiency 90nm (Mbps/M-$XORs$) | 15.7 | 21.96 | 101 | 185 | 283 | 726 | 360 |

EP 2 903 166 A1

Europäisches
Patentamt

European
Patent Office

Office européen
des brevets

## EUROPEAN SEARCH REPORT

Application Number

EP 14 29 0024

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | GARCIA-HERRERO F. ET AL: "Decoder for an enhanced serial generalized bit flipping algorithm", PROC., IEEE INTERNATIONAL CONFERENCE ON ELECTRONICS, CIRCUITS AND SYSTEMS (ICECS),, 9 December 2012 (2012-12-09), pages 412-415, XP032331652, DOI: 10.1109/ICECS.2012.6463662 ISBN: 978-1-4673-1261-5 * the whole document * | 1-13 | INV. H03M13/11 |
| A | GARCÍA-HERRERO F. ET AL: "Architecture of Generalized Bit-Flipping Decoding for High-Rate Non-binary LDPC Codes", CIRCUITS, SYSTEMS, AND SIGNAL PROCESSING, vol. 32, no. 2, 31 August 2012 (2012-08-31), pages 727-741, XP055113695, ISSN: 0278-081X, DOI: 10.1007/s00034-012-9481-3 * the whole document * | 1-13 | |
| A | GARCIA-HERRERO F. ET AL: "High-speed NB-LDPC decoder for wireless applications", 2013 INTERNATIONAL SYMPOSIUM ON INTELLIGENT SIGNAL PROCESSING AND COMMUNICATION SYSTEMS, IEEE, 12 November 2013 (2013-11-12), pages 215-220, XP032541962, DOI: 10.1109/ISPACS.2013.6704549 [retrieved on 2014-01-06] * the whole document *<br>-/-- | 1-13 | TECHNICAL FIELDS SEARCHED (IPC)<br><br>H03M |

The present search report has been drawn up for all claims

| Place of search | Date of completion of the search | Examiner |
|---|---|---|
| Munich | 14 April 2014 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 14 29 0024

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | GARCIA-HERRERO F. ET AL: "Multiple-Vote Symbol-Flipping Decoder for Nonbinary LDPC Codes", IEEE TRANSACTIONS ON VERY LARGE SCALE INTEGRATION (VLSI) SYSTEMS, [Online] 4 February 2014 (2014-02-04), pages 1-1, XP055113701, ISSN: 1063-8210, DOI: 10.1109/TVLSI.2013.2292900 [retrieved on 2014-04-11] * the whole document * ----- | 1-13 | |
| | | | **TECHNICAL FIELDS SEARCHED (IPC)** |

The present search report has been drawn up for all claims

| Place of search | Date of completion of the search | Examiner |
|---|---|---|
| Munich | 14 April 2014 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **M. DAVEY ; D. J. MACKAY.** Low density parity check codes over GF(q. *IEEE Commun. Letter,* June 1998, vol. 2, 165-167
- **L. BARNAULT ; D. DECLERCQ.** Fast decoding algorithm for LDPC over GF(2. *Proc. Info. Theory Workshop,* March 2003, 70-73
- **H. WYMEERSCH ; H. STEENDAM ; M. MOENE-CLAEY.** Log-domain decoding of LDPC codes over GF(q. *Proc. IEEE Intl. Conf. on Commun.,* June 2004, 772-776
- **C. SPAGNOL ; E. POPOVICI ; W. MARNANE.** Hardware implementation of GF(2m) LDPC decoders. *IEEE Trans. on Circuits and Syst.-I,* December 2009, vol. 56 (12), 2609-2620
- **D. DECLERCQ ; M. FOSSORIER.** Decoding algorithms for nonbinary LDPC codes over GF(q. *IEEE Trans. on Commun.,* April 2007, vol. 55, 633-643
- **C. POULLIAT ; M. FOSSORIER ; D. DECLERCQ.** Design of regular (2,dc)- LDPC codes over GF(q) using their binary images. *IEEE Trans. Commun.,* October 2008, vol. 56 (10), 1626-1635
- **V. SAVIN.** Min-max decoding for non binary LDPC codes. *Proc. IEEE ISIT,* July 2008, 960-964
- **A. VOICILA ; D. DECLERCQ ; F. VERDIER ; M. FOSSORIER ; P. URARD.** Low- Complexity Decoding for non-binary LDPC Codes in High Order Fields. *IEEE Trans. on Commun.,* May 2010, vol. 58 (5), 1365-1375
- **E. BOUTILLON ; L. CONDE-CANENCIA.** Bubble check: a simplified algo- rithm for elementary check node processing in extended min-sum non- binary LDPC decoders. *Electronics Letters,* April 2010, vol. 46, 633-634
- **X. ZHANG ; F. CAI.** Partial-parallel decoder architecture for quasi- cyclic non-binary LDPC codes. *Proc. of Acoustics Speech and Signal Processing (ICAS-SP),* March 2010, 1506-1509
- **D. ZHAO ; X. MA ; C. CHEN ; B. BAI.** A Low Complexity Decoding Algorithm for Majority-Logic Decodable Nonbinary LDPC Codes. *IEEE Commun. Letters,* November 2010, vol. 14 (11), 1062-1064
- **C. CHEN ; B. BAI ; X. WANG ; M. XU.** Nonbinary LDPC Codes Con- structed Based on a Cyclic MDS Code and a Low-Complexity Nonbinary Message-Passing Decoding Algorithm. *IEEE Commun. Letters,* March 2010, vol. 14 (3), 239-241
- **Y.-L. UENG ; C.-Y. LEONG ; C.-J. YANG ; C.-C. CHENG ; K.-H. LIAO ; S.- W. CHEN.** An efficient layered decoding architecture for nonbinary QC- LDPC codes. *IEEE Trans. on Circuits and Systems I: Regular Papers,* February 2012, vol. 59 (2), 385-398
- **J. LIN ; Z. YAN.** Efficient shuffled decoder architecture for nonbinary quasicyclic LDPC codes. *IEEE Trans. on Very Large Scale Integration (VLSI) Systems,* 2012, vol. 99, 1
- **X. CHEN ; C.-L. WANG.** High-throughput efficient non-binary LDPC decoder based on the Simplified Min-Sum algorithm. *IEEE Trans. On Circuits and Systems I: Regular Papers,* November 2012, vol. 59 (11), 2784-2794
- **X. ZHANG ; F. CAI ; S. LIN.** Low-Complexity Reliability-Based Message-Passing Decoder Architectures for Non-Binary LDPC Codes. *IEEE Trans. on Very Large Scale Integration (VLSI) Systems,* September 2011, vol. 20 (11), 1938-1950
- **F. GARCIA-HERRERO ; M. J. CANET ; J. VALLS.** Architecture of generalized bit-flipping decoding for high-rate non-binary LDPC codes. *Springer Circuits, Systems, and Signal Processing,* April 2013, vol. 32 (2), 727-741
- **F. GARCIA-HERRERO ; M.J. CANET ; J. VALLS.** Decoder for an Enhanced Serial Generalized Bit Flipping Algorithm. *IEEE International Conference on Electronics, Circuits and Systems (ICECS,* December 2012, 412-415
- **B. ZHOU ; J. KANG ; S. SONG ; S. LIN ; K. ABDEL-GHAFFAR ; M. XU.** Construction of non-binary quasi-cyclic LDPC codes by arrays and array dispersions. *IEEE Trans. on Commun.,* June 2009, vol. 57 (6), 1652-1662
- **L. AMARU ; M. MARTINA ; G. MASERA.** High speed architectures for finding the first two maximum/minimum values. *IEEE Trans. on Very Large Scale Integration (VLSI) Systems,* December 2012, vol. 20 (12), 2342-2346
- **X. ZHANG ; F. CAI.** Reduced-complexity decoder architecture for nonbinary LDPC codes. *IEEE Trans. on Very Large Scale Integration (VLSI) Systems,* July 2011, vol. 19 (7), 1229-1238
- **F. CAI ; X. ZHANG.** Relaxed Min-Max Decoder Architectures for Nonbinary Low-Density Parity Check Codes. *IEEE Transactions on Very Large Scale Integration (VLSI) Systems,* 2013

• **F. GARCIA-HERRERO ; D. DECLERCQ ; J. VALLS.** Non-Binary LDPC Decoder based on Symbol Flipping with Multiple Votes. *IEEE Commun. Letters,* 2013